Europäisches Patentamt

European Patent Office

Office européen des brevets

(19)

(11) EP 1 324 232 A2

(12) EUROPEAN PATENT APPLICATION

(43) Date of publication:
02.07.2003 Bulletin 2003/27

(51) Int Cl.7: G06F 17/50

(21) Application number: 02028782.7

(22) Date of filing: 23.12.2002

(84) Designated Contracting States:
AT BE BG CH CY CZ DE DK EE ES FI FR GB GR
IE IT LI LU MC NL PT SE SI SK TR
Designated Extension States:
AL LT LV MK RO

(30) Priority: 27.12.2001 JP 2001398319

(71) Applicant: Kabushiki Kaisha Toshiba
Tokyo 105-8001 (JP)

(72) Inventors:
• Matsuoka, Yoshiki, Int.Prop.Div., Toshiba Cor.
Tokyo (JP)

• Tsuchiya,Takehiko, Int.Prop.Div., Toshiba Cor.
Tokyo (JP)
• Nishide, Takeo, Int.Prop.Div., Toshiba Cor.
Tokyo (JP)
• Horikawa, Kazunari, Int.Prop.Div., Toshiba Cor.
Tokyo (JP)
• Yano, Eiichi, Int.Prop.Div., Toshiba Cor.
Tokyo (JP)

(74) Representative: HOFFMANN - EITLE
Patent- und Rechtsanwälte
Arabellastrasse 4
81925 München (DE)

(54) Lsi design verification apparatus, method and program

(57) A computer implemented method for design verification using logical simulation of a circuit description having a plurality of hierarchies from top to bottom in accordance with abstraction of circuit components, which have an arithmetic and logic function, reads the circuit description and analyzes signal connection topologies between the hierarchies of the circuit description from top to bottom. The method stores the data of the signal connection topologies. The method reads properties of target modules implemented by the circuit components in the circuit description. The method extracts a property part having a signal communicating between the target modules. The method extracts an output operation property, defining output operation of an output side module, and an expecting operation property, defining an expecting operation of an input side module among the properties of the target modules. The method compares the output operation properties with the expecting operation properties.

FIG. 1

CENTRAL PROCESSING UNIT (CPU) — 2

DATA STORING UNIT ~9
CIRCUIT DESCRIPTION READING UNIT ~10
ANALYSIS UNIT ~11
PROPERTY READING UNIT ~12
INTER-MODULE PROPERTY EXTRACTION UNIT ~13
SIGNAL OPERATION PORTION EXTRACTION UNIT ~14
COMPARATOR ~15
MISMATCH DETECTOR ~16
REPORT GENERATOR ~17
REDUNDANT PORTION DELETION UNIT ~18
REGISTER INSERTION UNIT ~19
DISPLAY UNIT ~20

INPUT DEVICE — 31
OUTPUT DEVICE — 32
INPUT/OUTPUT CONTROL DEVICE — 33
MAIN MEMORY — 35
DATA STORAGE DEVICE — 4

## Description

## CROSS REFERENCE TO RELATED APPLICATIONS

This application is based upon and claims the benefit of priority from prior Japanese Patent Application P2001-398319 filed on December 27, 2001; the entire contents of which are incorporated by reference herein.

## BACKGROUND OF THE INVENTION

### 1. Field of the Invention

The present invention relates to an LSI design verification apparatus, an LSI design verification method, and an LSI design verification program for comparing properties and circuit descriptions which are parts of formal verification.

### 2. Description of the Related Art

During a process of designing a semiconductor integrated circuit, there is usually employed a method of representing a circuit configuration to be implemented in the form of a register transfer level (RTL) description and then logically compiling the RTL description into a gate-level netlist. The RTL description corresponds to representation of a circuit configuration, in the form of a description corresponding to a combinational logic gate for implementing a specific function and a description relating to transfer of data among registers such as flip-flops and latches. Further, the gate-level netlist corresponds to representation of a circuit configuration through use of logic formulas of gate elements.

Then, mask patterns are formed from an upper side of the gate level description, thus manufacturing an actual semiconductor integrated circuit.

However, because of recent enlargements in and increased complexity of circuits, in a conventional verification method that has used a model and a test vector, a great deal of verification time has become necessary, and the applicability of human verification made by considering all the cases has reached its limit. Therefore, recently, formal verification methods, of which one verification method makes use of property checks that verify matches between specifications and a circuit by comparing circuit description with properties (expressing operation use in a given form) have begun to be introduced.

The formal verification described here has two meanings, i.e., a property check and logic equivalence verification. The "property check" means verification as to whether or not a designed logical circuit satisfies design specifications (or properties). The "logic equivalence verification" means verification as to whether or not two circuits are logically equivalence to each other. However, in the logic equivalent verification, only equivalence between the two circuits can be verified, but it is not known whether or not logical functions intended by a designer have been realized. In order to verify this realization, for example, a simulation or a property check must be carried out.

Generally, in the property check, exhaustive checking can be carried out by comparison using a simulation verification method by a test vector. However, because of a limitation on an applicable circuit size, properties must be divided into modules, and then verified for each module. Therefore, properties between the modules cannot be verified. Consequently, the properties of each module are completely independent, and validity of a correlation between the properties cannot be verified. Accordingly, regarding the optimization of interface specifications between the modules, even if specifications have timing room in a multi-cycle path, a determination must be made manually based on a simulation waveform. Thus, the optimization of interface specifications between the modules is extremely difficult, and careless adjustment may cause a shift in timing to mix defects therein. As a result, there is a problem that the optimization of interface specifications has not been carried out so often.

Further, recently, a method has been used for extracting so-called corner case bugs, which occur under complex conditions, by a simulation environment efficiency tool for automatically generating random test vectors. However, as a verifier manually builds this simulation environment from the properties of a module to be verified, a great deal of time is required, and accuracy is lacking. In addition, as randomly generated test vectors include many test vectors, which cannot be inputted because of specifications thereof, simulation time is extended, and a great deal of time is consequently necessary for verification.

In addition, no methods have been established to determine whether or not specifications allow a function realized by an inactivation code portion to be activated during simulation, regarding a code activation rate obtained by measuring the presence of executed HDL source codes. Consequently, an area reduction by redundant description deletion based on inactivation code information is not enabled.

## SUMMARY OF THE INVENTION

An apparatus for design verification using logical simulation of a circuit description, having a plurality of hierarchies from top to bottom in accordance with abstraction levels of circuit components, the apparatus includes: a circuit description reading unit configured to read the circuit description; an analysis unit configured to analyze signal connection topologies between the hierarchies of the circuit description from top to bottom; a data storing unit configured to store data of the signal connection topologies; a property reading unit configured to read properties of target modules implemented by the circuit components in the circuit description; an inter-module property extraction unit configured to extract a property part having a signal communicating between the target modules; a signal operation portion extraction unit configured to extract output operation properties, defining output operation of an output side module, and an expecting operation property, defining an expecting operation of an input side module among the properties of the target modules; and a comparing unit configured to compare the output operation properties with the expecting operation properties.

An apparatus for design verification using logical simulation of a circuit description, a plurality of hierarchies from top to bottom in accordance with abstraction of circuit components, the apparatus includes: a circuit description reading unit configured to read the circuit description; an analysis unit configured to analyze a signal connection topologies between the hierarchies of the circuit description from top to bottom; a property generation unit configured to generate a property description constituted by a signal topology connected to a target module from the property description of a module providing an input to the target module, the target module being implemented by the circuit component; a first test bench generation unit configured to generate a test vector and a first test bench description; and a second test bench generation unit configured to generate a second test bench description for comparing a simulation output and a specification output from the property description of the target module.

A computer implemented method for design verification using logical simulation of a circuit description having a plurality of hierarchies from top to bottom in accordance with abstraction of circuit components, the method includes: reading the circuit description; analyzing signal connection topologies between the hierarchies of the circuit description from top to bottom; storing data of the signal connection topologies to a data storing device; reading properties of target modules implemented by the circuit components in the circuit description: extracting a property part having a signal communicating between the target modules; extracting an output operation property, defining output operation in an output side module, and an expecting operation property, defining an expecting operation of an input side module among the properties of the target module; and comparing the output operation properties with the expecting operation properties.

A computer implemented method for design verification using logical simulation of a circuit description having a plurality of hierarchies from top to bottom in accordance with abstraction of circuit components, the method includes: reading the circuit description; analyzing signal connection topologies between the hierarchies of the circuit description from top to bottom; generating a property description constituted by a signal topology connected to a target module from the property description of a module providing an input to the target module, the target module being implemented by the circuit components; generating a test vector and a first test bench description; and generating a second test bench description comparing a simulation output and a specification outputs from the property description of the target module.

A computer program product for use with a design verification apparatus, wherein the apparatus uses logical simulation of a circuit description having a plurality of hierarchies from top to bottom in accordance with abstraction of circuit components, the computer program product includes: instructions configured to read the circuit description; instructions configured to analyze signal connection topologies between the hierarchies of the circuit description from top to bottom; instructions configured to store data of the signal connection topologies to a data storing device; instructions configured to read properties of target modules implemented by the circuit components in the circuit description; instructions configured to extract a property part having a signal communicating between the target modules; instructions configured to extract an output operation property, defining output operation in an output side module, and an expecting operation property, defining an expecting operation of an input side module among the properties of the target module; and instructions configured to compare the output operation properties with the expecting operation properties.

A computer program product for use with a design verification apparatus, wherein the apparatus uses logical simulation of a circuit description having a plurality of hierarchies from top to bottom in accordance with abstraction of circuit components, the computer program product includes: instructions configured to read the circuit description; instructions configured to analyze signal topology connection topologies between the hierarchies of the circuit description from top to bottom; instructions configured to generate a property description constituted by a signal connected to a target module from the property description of a module providing an input to the target module, the target module being implemented by the circuit component; instructions configured to generate a test vector and a first test bench description; and instructions configured to generate a second test bench description comparing a simulation output and a specification output from the property description of the target module.

## BRIEF DESCRIPTION OF THE DRAWINGS

FIG. 1 is a block diagram illustrating a LSI verification apparatus according to the first embodiment of the present invention.
FIG. 2 is a circuit diagram illustrating an experimental circuit of the LSI verification apparatus shown in FIG.1.
FIG. 3 is an exemplary diagram illustrating a data storage device 4 shown in FIG.1

FIG. 4A is a view showing an example of property information for MULT side shown in FIG.2.

FIG. 4B is a view showing an example of property information in a CON side shown in FIG.2.

FIG. 5 is a flowchart illustrating the LSI design verification method of the first embodiment of the present invention.

FIG.6A and FIG.6B are flowcharts illustrating process flows for generating the data storage device shown in FIG.5.

FIG. 7A is a view showing a list of the MULT signal shown in FIG.2.

FIG. 7B is a view showing a list of CON signal shown in FIG.2.

FIG.8A and FIG.8B is a flow chart illustrating a flow of a process for analysis of the inter-module signal properties shown in FIG.5.

FIG.9 is a flow chart illustrating a process for extracting an inter-module signal and a signal operation portion shown in FIG.5.

FIG.10A is illustrating an example of property for CON side shown in FIG.2.

FIG.10B is illustrating an example of converted property for CON side shown in FIG.2.

FIG.11 is a flow chart illustrating a process for comparing shown in FIG.5.

FIG.12 is a flow chart illustrating a process for inserting a register shown in FIG.5.

FIG.13 is a view showing an example of waveform displaying in the LSI design verification method according to the first embodiment of the present invention.

FIG. 14A is a view showing an example of properties for single MULT verification, which are used in the embodiment 1-1 of the LSI design verification method according to the first embodiment of the present invention.

FIG. 14B is a view showing an example of properties for single CON verification.

FIG. 15 is a conceptual diagram showing an LSI design verification method according to a second embodiment of the present invention.

FIG. 16 is a constitutional view of an LSI design verification apparatus according to the second embodiment of the present invention.

FIG. 17 is a circuit diagram showing an experimental circuit used in FIG.16.

FIG. 18 is a view showing a module constitution of the experimental circuit ALU shown in FIG.17.

FIG. 19 is a flowchart illustrating the LSI design verification method according to the second embodiment of the present invention.

FIG. 20 is a flowchart illustrating a process for analysis of the inter-module signal properties shown in FIG.19.

FIG. 21 is a view showing a module structure of the experimental circuit according to the second embodiment of the present invention.

FIG. 22A is a view showing an example of a CON input connection relation shown in FIG.17.

FIG. 22B is a view showing an ALU input connection relation shown in FIG.17.

FIG. 23 is a flowchart illustrating a process for extracting a relational property shown in FIG.19.

FIG. 24A is an example for property of a single ALU verification according to the second embodiment of the present invention.

FIG. 24B is an example for property of a single CON verification according to the second embodiment of the present invention.

FIG. 24C is an example for property description p (CON_>ALU) according to the second embodiment of the present invention.

FIG. 25 is a flow chart illustrating a first converting process of a description shown in FIG.19.

FIG. 26A is an exemplary view showing test bench description of a driving task section according to the second embodiment of the present invention.

FIG. 26B is an exemplary view showing test bench description of a class declaration section according to the second embodiment of the present invention.

FIG. 27A is an exemplarly view showing a mixed description according to the second embodiment of the present invention.

FIG. 27B is a view showing a mixed description example.

FIG. 28 is a flowchart illustrating a second converting process of a description shown in FIG.19.

FIG. 29A is a view showing an exemplary test bench description of a task section of a circuit ALU-2 according to the second embodiment of the present invention.

FIG. 29B is a view showing an exemplary test bench description of the task section of a circuit ALU-2 according to the second embodiment.

FIG. 29C is a view showing an exemplary test bench description of a task section of an ALU-1.

FIG. 30A is a view showing an exemplary test bench description of a task section of a circuit ALU-3 according to the second embodiment of the present invention.

FIG. 30B is a view showing an exemplary test bench description T (drive_TASK) of the task section according to the second embodiment of the present invention.

FIG. 30C is a view showing an exemplary test bench description T (ALU-all) of the task section according to the second embodiment of the present invention.

FIG. 30D is a view showing an exemplary test bench description T (check_DECLARE) of a class declaration section according to the second embodiment of the present invention.

FIG. 31 is a flowchart illustrating a process for generating a description shown in FIG.19.

FIG. 32A is a view showing an exemplary test bench description of a top main section according to the second embodiment of the present invention.

FIG. 32B is a view showing an exemplary model description for simulation according to the second embodiment of the present invention.

FIG. 33 is a flowchart illustrating processes between step S36 and step S40 in FIG.19.

FIG. 34A is a view showing an example for an inactivation code report R (UA1).

FIG. 34B is a view showing an example for an inactivation code report R (UA2).

FIG. 35 is a flowchart illustrating a process for determining whether or not there is a possibility for an activation shown in FIG.19.

FIG. 36 is a flowchart illustrating processes between step S41 and step S45 in FIG.19.

FIG. 37 is an example for modified model description M (ALU-1) according to the second embodiment of the present invention.

FIG. 38 is an example for test bench description T (cst1) for random limitation according to the second embodiment of the present invention.

FIG. 39 is an example for test bench description T (cst2) for random limitation according to the second embodiment of the present invention.

## DETAILED DESCRIPTION OF EMBODIMENTS

Various embodiments of the present invention will be described with reference to the accompanying drawings. It is to be noted that the same or similar reference numerals are applied to the same of similar parts and elements throughout the drawings, and the description of the same or similar parts and elements will be omitted or simplified.

In the following descriptions, numerous specific details are set fourth such as specific signal values, etc. to provide a thorough understanding of the present invention. However, it will be obvious to those skilled in the art that the present invention may be practiced without such specific details in other instances, well-known circuits have been shown in block diagram form in order not to obscure the present invention in unnecessary detail.

## FIRST EMBODIMENT

## - ARCHITECTURE OF LSI DESIGN VERIFICATION APPARATUS

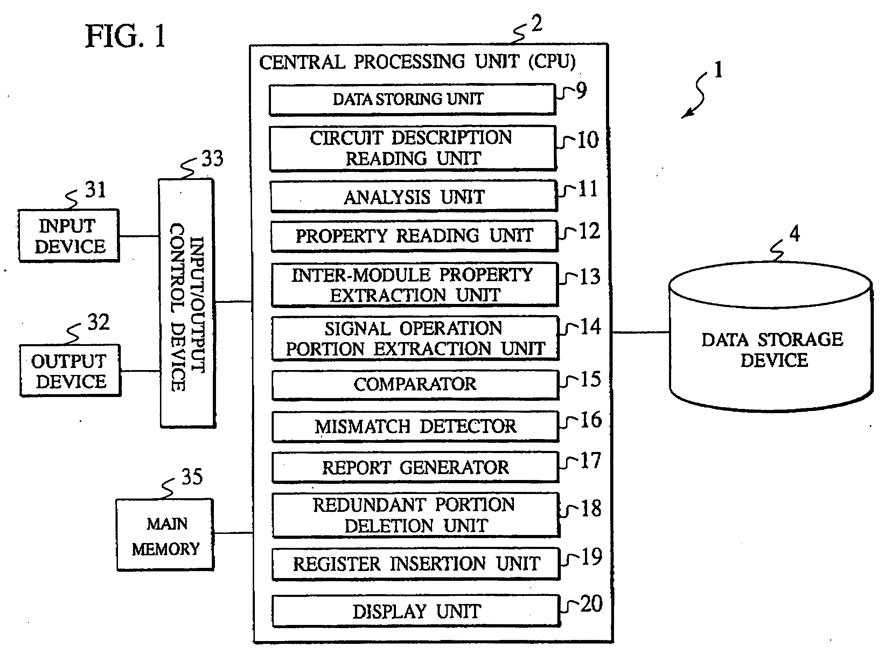

An LSI design verification apparatus 1 of a first embodiment shown in FIG. 1 includes at least a central processing unit (CPU) 2, an input device 31 and an output device 32 connected through an input/output control device 33 to the CPU 2, a data storage device 4 connected to the CPU 2, and a main memory 35. The CPU 2 is provided with a database management unit for which the drawing is omitted. When an input/output with the data storage device 4 is necessary, a storage place of a necessary file is searched to read out/write the file through this database management unit.

The CPU 2 includes at least a data storing unit 9, a circuit description reading unit 10, an analysis unit 11, a property reading unit 12, an inter-module property extraction unit 13, a signal operation portion extraction unit 14, a comparator 15, a mismatch detector 16, a report generator 17, a redundant portion deletion unit 18, a register insertion unit 19, and a display unit 20.

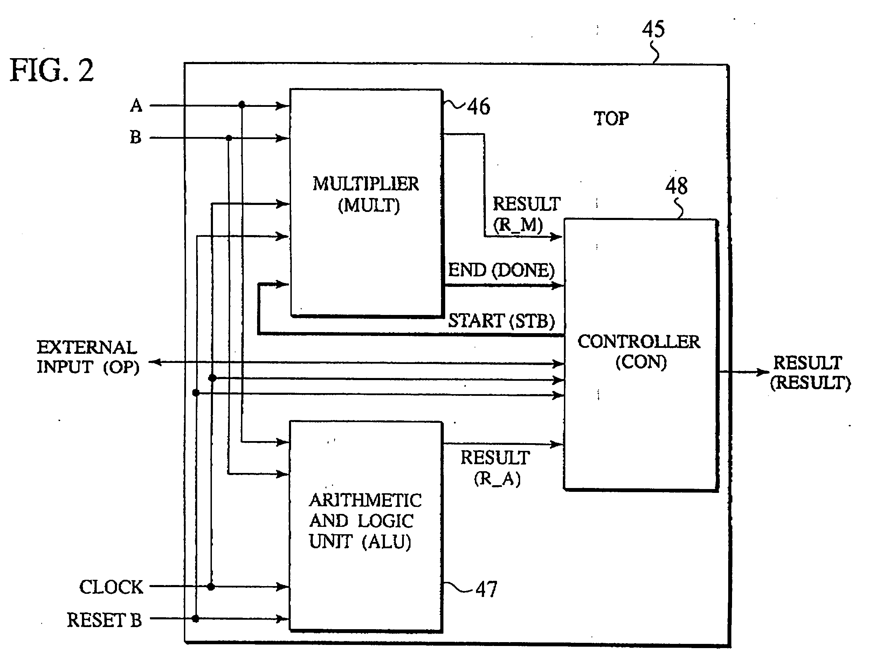

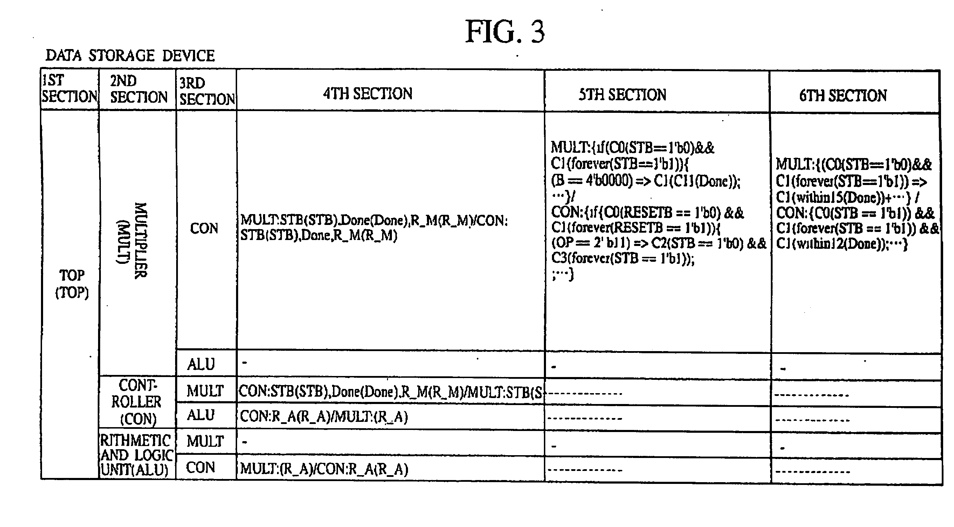

The data storing unit 9 controls storing data on a signal connection relation between hierarchies in the data storage device 4. The circuit description reading unit 10 reads circuit description of an experimental circuit in the LSI design verification apparatus 1. The analysis unit 11 analyzes a connection relation and a signal input/output relationship between modules, such that a multiplier (MULT) 46, a controller (CON) 48, and an arithmetic and logic unit (ALU) in a TOP module 45 shown in FIG.2 and FIG.3, in a top hierarchy for the circuit description. The property reading unit 12 reads properties of each module to be verified from the data storage device 4 in the LSI design verification apparatus 1. The inter-module property extraction unit 13 extracts a section including a signal between the modules (hereinafter, referred to as "inter-module signal properties") from the read properties of each module to be verified. The signal operation portion extraction unit 14 extracts signal operation portions of properties that exist in a module of a signal output side to define an output operation (referred to as "output operation properties", hereinafter), and also extracts properties that exist in an input side module to define an expected operation (referred to as "expected operation properties", hereinafter) from the extracted inter-module signal properties. The comparator 15 compares properties of output and input sides of each signal by using the signal operation portions of the output operation properties and the expected operation properties. The mismatch detector 16 compares conditions of the properties to detect mismatched conditions if a result of the comparison specifies a common signal between the modules to be verified is specified. This common signal is described as a property condition. The report generator 17 generates an error report if mismatched conditions are detected by the mismatch detector 16. The redundant portion deletion unit 18 deletes a signal redundant portion if interface specifications have room, and a hierarchical design method is not used. The register insertion unit 19 inserts a register into a hierarchical boundary of a signal if interface specifications have room, and the hierarchical design method is used. The display unit 20 displays a transient waveform of the signal regarding a mismatched content based on the report transferred from the report generator 17.

The input device 31 includes a keyboard, a mouse, a recognition device such as an optical character reader (OCR), a graphic input device such as an image scanner, and a special input device such as a voice recognition device. The output device 32 includes a display device such as a liquid crystal display (LCD) or a cathode ray tube (CRT) display, and a printer such as an ink jet printer or a laser printer. The input/output control device (input/output interface) 33 is an interface for connecting the input device 31, the output device 32, and a reading unit which reads data from an external storage medium, such as a compact disk ROM, a magnetic optical disk (MO) or a flexible disk (FD), to the CPU 2. In terms of data flow, the input/output control unit 33 works as an interface for the input device 31, the output device 32, and the reading unit of the external storage device. The main memory 35 includes a read only memory (ROM) and a random access memory (RAM). The ROM functions as a program memory for storing programs to be executed in the CPU 2. The RAM functions as a temporary data memory used as a working area for temporarily storing data used during program execution in the CPU 2. The data storage device 4 stores circuit description information for an module names (or an top hierarchies) in a module unit.

**- SPECIFICATIONS OF EXPERIMENTAL CIRCUIT**

As shown in FIG. 2, specifications of the experimental circuit used in the first embodiment of the present invention will be explained.

The experimental circuit 45 used in the first embodiment of the present invention includes a top hierarchy (TOP) and a second hierarchy (lower hierarchy), which is constituted of a multiplier (MULT) 46, an arithmetic logic unit (ALU) 47, and a controller (CON) 48. When the circuit description reading unit 10. shown in FIG.1, reads the experimental circuit 45 and the analysis unit 11 analyses a connection relation between the modules of the experimental circuit 45 in the top hierarchy, signal input/output relations, shown in following (a) through (d), are analyzed.

(a) As shown in FIG. 2, a signal A and a signal B having 4-bit data, an external input signal (OP) having a 2-bit command, a clock signal (CLK), and a reset signal B (RESETB) are inputted in the top hierarchy. Then, an arithmetic operation is performed on the signal A and the signal B in accordance with a content of the external input signal (OP), the result of which is outputted as a result signal (RESULT) composed of 8-bit data. The external input signal (OP) can select an "AND" operation, addition, subtraction or multiplication.

(b) The signal A and the signal B, a starting signal (STB), the clock signal (CLK), and the reset signal B (RESETB) are inputted to the multiplier (MULT) 46 of the lower hierarchy (second hierarchy). In the MULT 46, when the starting signal is asserted, multiplication is performed on the signal A and the signal B, the result of which is outputted as a result signal (RESULT). Then, when the operation is finished, an termination signal (Done) is asserted. An arithmetic consumption cycle changes by 11 to 15 cycles depending on a content of the data of the signal B.

(c) The a signal A and a signal B, the external input signal (OP), the clock signal (CLK), and the reset signal B (RESETB) are inputted to the ALU 47 of the lower hierarchy (second hierarchy). In the ALU 47, in accordance with a content of the external input signal (OP), an arithmetic operation is performed on the signal A and the signal B, the result of which is outputted as a result signal (RESULT). The external input signal (OP) can select an AND operation, addition, and subtraction.

(d) The external input signal (OP), the termination signal (Done) of the multiplier (MULT) 46, and an arithmetic operation result of the MULT 46, composed of 8-bit (R_M), an 8-bit operation result (R_A) of the ALU 47, the clock signal (CLK), and the reset signal B (RESETB) are inputted to the controller (CON) 48 of the lower hierarchy (second hierarchy). In the CON 48, signals from the ALU 47 and the MULT 46 are separately outputted as operation results (RESULT) based on the content of the external input signal (OP). The CON 48 also controls the starting signal (STB) for operating the MULT 46. Further, the CON 48 outputs the operation result after reception of the termination signal (Done) from the MULT 46. If the termination signal (Done) from the MULT 46 is not returned for 8 cycles after 12 cycles, an error is determined.

**- EXAMPLE OF DATA STORING DEVICE**

FIG. 3 shows the data structure of the data storage device 4. The data storage device 4 stores a module name of a top hierarchy (first section), a module name included in the module of the top hierarchy (second section), a combination of each module (third section), connection information between modules (fourth section), property information regarding an extracted signal (fifth section), and property information converted for each combination of signals (sixth section) for each module.

For example, a result such as that shown in FIG.2 from the analysis of the top hierarchy, as shown in FIG. 3, first, a module name of the top hierarchy "TOP" is stored in the first section of the data storage device 4. Then, the module name included in the "TOP 45" is stored in the second section. Here, "the multiplier (MULT) 46, the controller (CON) 48, and the arithmetic logic unit (ALU) 47" are stored in the second section.

Then, in the third section, combination information of the modules stored in the second section is stored. For example, for the multiplier (MULT) 46, since a combination of the controller (CON) 48 and the arithmetic logic unit (ALU) 46 is extracted, the CON 48 and the ALU 47 are stored in the third section corresponding to the MULT 46 of the second section. Similarly, for the CON 48, since a combination of the MULT 46 and the ALU 47 is extracted, the MULT 46 and the ALU 47 are stored in the third section corresponding to the CON 48 of the second section. Further, for the ALU 47, since a combination of the MULT 46 and the CON 48 is extracted, the MULT 46 and the CON 48 are stored in the third section corresponding to the ALU 47 of the second section.

In the fourth section, connection information between the modules extracted in the second section is stored. For example, for the multiplier (MULT) 46 of the second section, combinations of the MULT 46 with the controller (CON), and the MULT 46 with the arithmetic logic unit (ALU) 47 are extracted from the third section, and connection relations of these two combinations are stored in the fourth section. Accordingly, in the embodiment shown in FIG. 3, as a connection relation between the MULT 46 and the CON 48, a connection relation of the MULT 46 and the CON 48, i.e., "MULT: STB (STB), Done (Done), R_M(R_M)/CON: STB(STB), Done (Done), R_M(R_M)", is stored in the fourth section. Then, since no connection relation exists between the MULT 46 and the ALU 47, nothing is stored in the fourth section for storing the connection relation between the MULT 46 and the ALU 47.

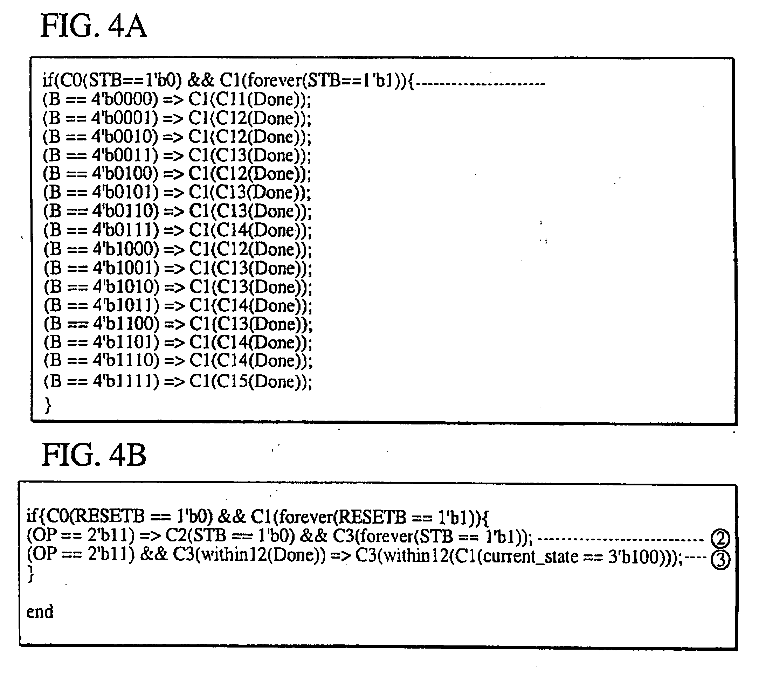

In the fifth section, property information regarding the extracted signal is stored. That is, property information regarding the signal (STB, Done, R_M) extracted in the fourth section as the connection relation between the module multiplier (MULT) 46 and the controller (CON) 48 is extracted from properties of each of the MULT 46 and the CON 48 to be stored in the fifth section. For example, as properties including the signal "STB, Done, R_M" extracted in the fourth section, in the MULT 46 side, property information shown in FIG. 4A is extracted, and in the CON 48 side, property information shown in FIG. 4B is extracted, to be stored in the fifth section.

In the sixth section, property information converted for each combination of signals is stored for each module. That is, properties of a related signal operation extracted from the properties of the fifth section, excluding the properties of an unrelated signal between the two modules, are stored in the sixth section.

## - EXAMPLE OF SIGNAL PROPERTIES BETWEEN MODULES

FIG. 4A shows an example of properties for single verification of the multiplier (MULT) 46 as one of the modules. Here, after the starting signal (STB) is asserted, by a value of the signal B, verification is made as to the completion of an operation in 11 to 15 cycles. Reference code C in FIG. 4A denotes a cycle, and "C1" means a case after 1 cycle.

FIG. 4B shows an example of properties for single verification of the controller (CON) 48. Here, two operations are verified. One of the operations to be verified is that when the external input signal (OP) is multiplication (2'11) after disenabling the reset condition, the starting signal (STB) asserts 1 after 3 cycles. The other operation to be verified is that termination (current_sate==,3'b100) which occurs when the termination signal (Done) is returned within 12 cycles after the start of execution of the multiplier (MULT) 46 when the external input signal (OP) is multiplication (2'b11) after disenabling the reset condition.

## - LSI DESIGN VERIFICATION METHOD

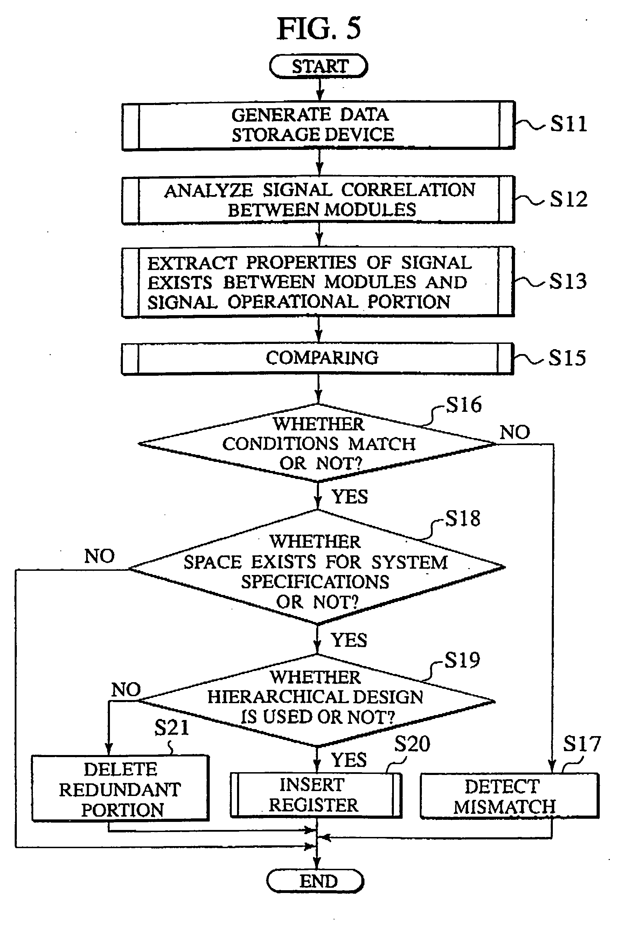

The LSI design verification method, shown in FIG.5, according to the first embodiment of the present invention is described as follows.

(a) In step S11, the circuit description reading unit 10 reads a circuit description 41, or an RTL.

(b) In step S12, the analysis unit 11 analyzes the circuit description 41 from a top hierarchy, and analyzes a connection relation between the modules of a second hierarchy (lower hierarchy). Then, data defining (i) what signal exists between the modules, (ii) which module the signal is outputted from and which module the signal is inputted to, and (iii) by what kind of signal name the signal is transferred between the module, are stored in the data storage device 4 shown in FIG. 3. For example, the circuit description 41 shown in FIG. 2 is read in step S11. Furthermore, in step S12, by analyzing a top hierarchy 45, connection relation between a multiplier (MULT) 46 and an arithmetic logic unit (ALU) 47, between the MULT 46 and a controller (CON) 48, and between the ALU 47 and the CON 48 are analyzed. Then the data storing unit 9 stores the analyzed connection relation in the data storage device 4 shown in FIG.3.

(c) In step S13, the property reading unit 12 reads the properties of each module (properties of each module to be verified) to be compared. The inter-module property extraction unit 13 detects and extracts "inter-module signal properties" from the data storage device 4. According to the first embodiment of the present invention, the property reading unit 12 reads property A and property B. Then, the inter-module property extraction unit 13 detects and extracts inter-module properties (property A' and property B') of the property A and the property B from the data storage device 4. Further, the signal operation portion extraction unit 14 extracts signal operation portions of "output operation properties" and "expected operation properties" from the extracted inter-module signal properties.

(d) In step S15, the comparator 15 compares properties of the output and input sides of each signal by using the signal operation portions of the output operation properties (output side) and the expected operation properties (input side) extracted in step S13.

(e) In step S16, the mismatch detector 16 determines whether or not conditions match, when a common signal is used within the objected modules for comparison and the signal has been described as a condition in the properties. When the result of the determination in step S16 shows a mismatch between the conditions, the mismatched conditions are identified and the report generator 17 generates an error report in step S17. In other words, as a result of comparing properties in step S16, when either one of the properties is missing, substitutes are extracted from the properties of other hierarchies, and the extracted substitutes are converted into the hierarchy where the compared properties exists. At this time, a time-domain change in a related signal is displayed as a waveform on a screen.

(f) In step S18, whether or not interface specifications have additional coverage is determined, when the conditions of the properties match as a result of the determination in step S16. When interface specifications do not have additional coverage, the process is ended. When interface specifications have additional coverage, whether or not a hierarchical design method is used is determined in step S19. When the hierarchical design method is used, the register insertion unit 19 inserts a register into a hierarchical boundary of the signal and ends the process in step S20. When the hierarchical design method is not used, the redundant portion deletion unit 18 deletes redundant portions of the signal and ends the process.

## METHOD 1: WHEN THERE IS MISMATCH BETWEEN PROPERTIES

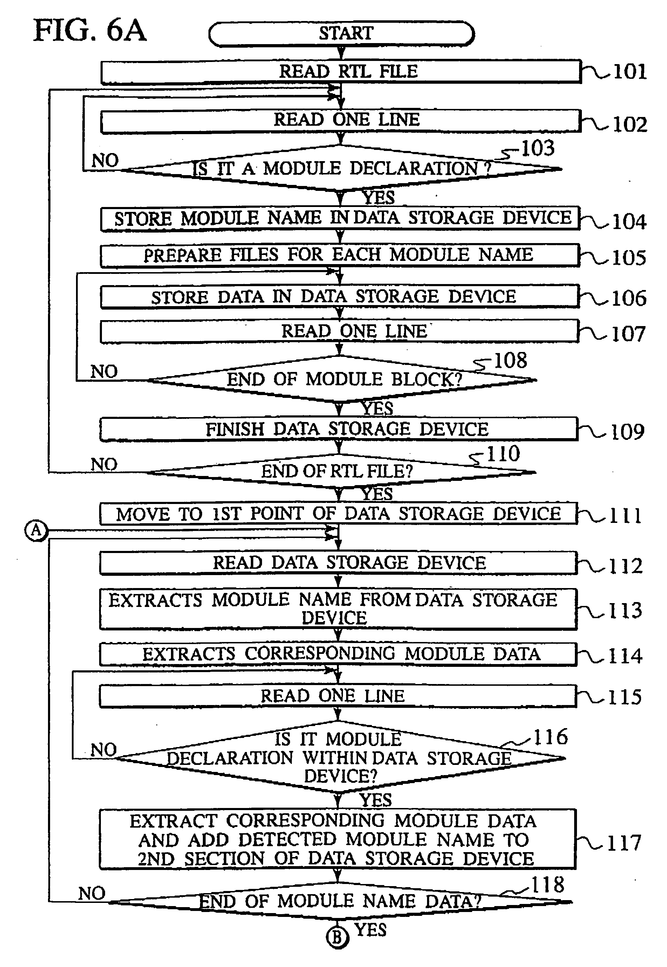

Next, a description will be made of an example when there is mismatch between properties in line with the foregoing LSI design verification method, in the LSI design verification method of the first embodiment of the present invention, by use of Figs. 6A to 12.

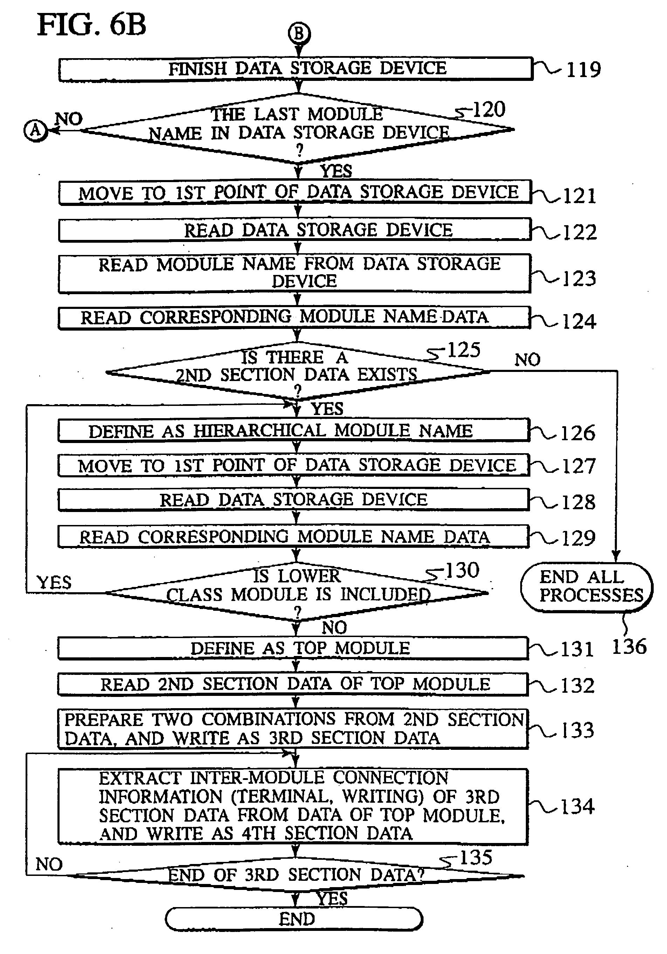

Corresponding to steps S11 shown in FIG.5, the process for generating a signal list 40 indicating a connection relation of signals between modules from a top hierarchy to a lower hierarchy (second hierarchy) in processes from step S101 to step S136 of FIG.6A and FIG.6B is described here as METHOD 1. Especially, the procedures generating the multiplier (MULT) 6, the controller (CON) 48, and the arithmetic logic unit (ALU) 47 shown in FIG.2 and storing them in the data storage device 4 are described. In addition, comparison is made to a relation between the MULT 46 and the CON 48 here.

(a) In step S101 of FIG. 6A. an RTL file 41, circuit description of the top hierarchy, is read. Then, in step S102. the circuit description reading unit 10 reads one line from the RTL file 41.

(b) In step S103, whether or not module declaration has been made is determined. When no a module declaration has been made, the process returns to step S102 where the next line of the RTL file 41 is going to be read. When a module declaration has made, the processing proceeds to step S104.

(c) In step S104, a module name of the module declaration is stored in the first section of the data storage device 4. Then, in Step S105, a database for each module name (i.e., database for each top hierarchy) is made within the data storage device 4.

(d) In step S107, data of the module name database 5 are read line by line. Then, in step S108, whether or not all the data in a module block has been read is determined. If the reading of the data of the module block has not yet finished, the process returns to step S106, where the data is written in the module name database 5. If the reading of the data of the module block has finished, the processing proceeds to step S109.

(e) In step S110, whether or not a last line of the RTL file 41 has been reached is determined. If the last line has not yet been reached, the process returns to step S102, and the process from step S102 to S110 is repeated. If the last line has been reached, the processing proceeds to step S111.

(f) In step S111, the processing proceeds to a first point of the data storage device 4. Then, in step S112, the data storage device 4 is read, and in step S113, a module name of the first section is acquired from the data storage device 4. Then, in step S114, data for each corresponding module name is acquired.

(g) In step S115, one line of the acquired data in step S104 is read. Then, in step S116, whether or not data for which module declaration has been made exists in the data storage device 4 is detected. If there is no data having a module declaration, the process returns to step S115, where a line of next data of the acquired data in step S104 is read. If there is data having a module declaration, a module name is detected and the processing proceeds to step S117.

(h) In step S117, the detected module name is added to the second section of the data storage device 4. In step S118, whether or not a last line of the module name data has been reached is determined. If the last line has not yet been reached, the process returns to step S112, and the process from step S112 to step S117 is repeated. If the last line has been reached, in step S119, the module name data is closed.

(i) In step S120, whether or not a last module name of the data storage device 4 has been reached is determined. If the last module name has not been reached, the process from step S112 to Step S119 is repeated. If the last module name has been reached. the process moves to a first point of the data storage device 4 in step S121.

(j) In step S122, the data storage device 4 is read. Then, in step S123, a module name is acquired from the data storage device 4. In step S114, data for each corresponding module name is acquired.

(k) In step S125, whether or not data of the second section exists is determined. If there is no data for the second section, in step S136, all the processes are ended. If there is data for the second section, the data is defined as a hierarchical module name in step S126. Then, in step S127, the processing proceeds to a first point of the data storage device 4.

(l) In step S128, the data storage device 4 is read. In step S129, data for each corresponding module name is acquired. Then, in step S130, whether or not a lower module is included is determined. If a lower module is included, the process returns to step S126 to define the lower module as a hierarchical module name, and the process from step S126 to S129 is repeated. In step S130, if no lower modules are included, the processing proceeds to step S131, where the data is defined as a top module.

(m) In step S132, data of the second section of the top module is acquired. Then in step S133, a combination of two modules is generated from the data of the second section, and the combination is stored in the third section of the data storage device 4.

(n) Then, in step S134, inter-module connection information (terminal or wiring) of the data of the third section is extracted from the data for each corresponding module name of the top hierarchy, and stored in the fourth section of the data storage device 4. Then, in step S135, whether or not the information is the last data of the third section is determined. If the information is not the last data of the third section, the process of the step S134 is repeated. If the information is the last data of the third section, common terminal information between the modules is extracted, and the process is ended.

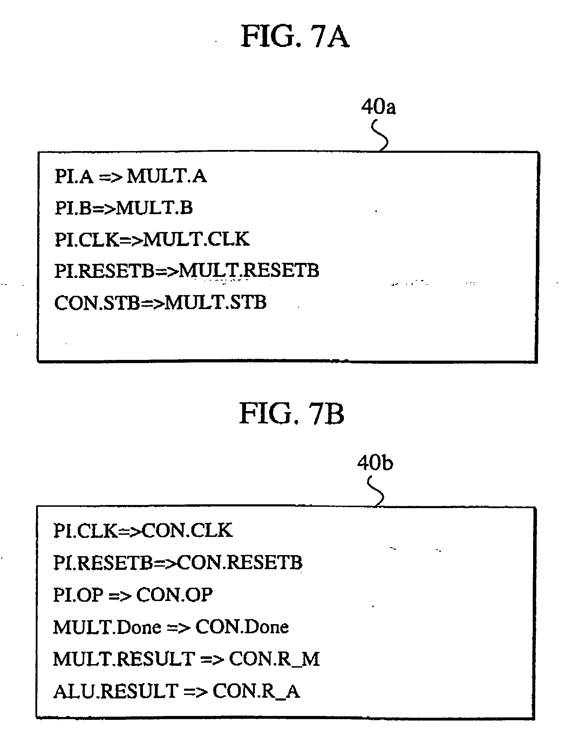

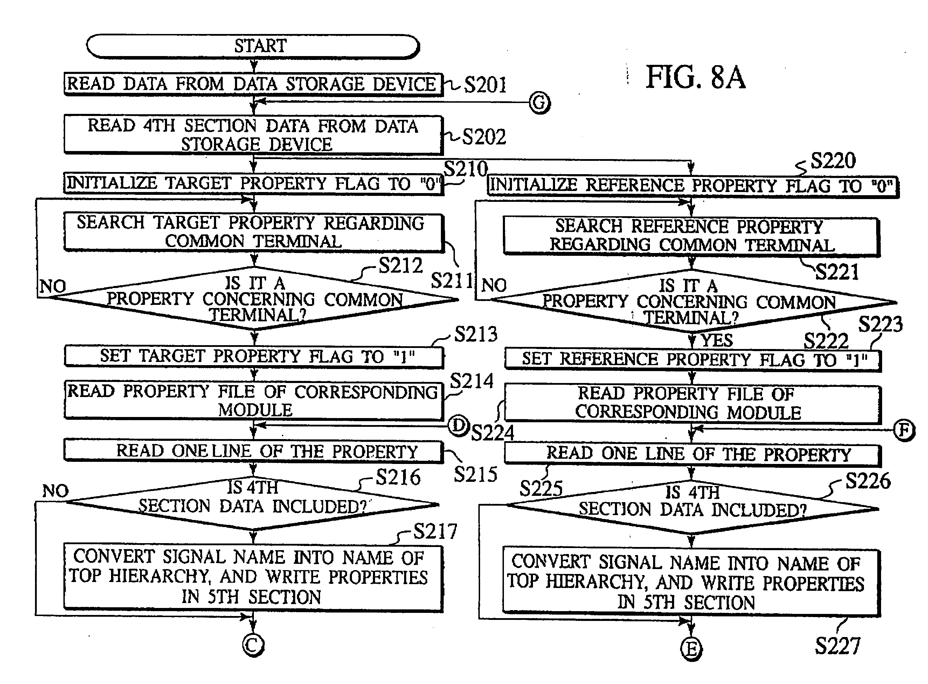

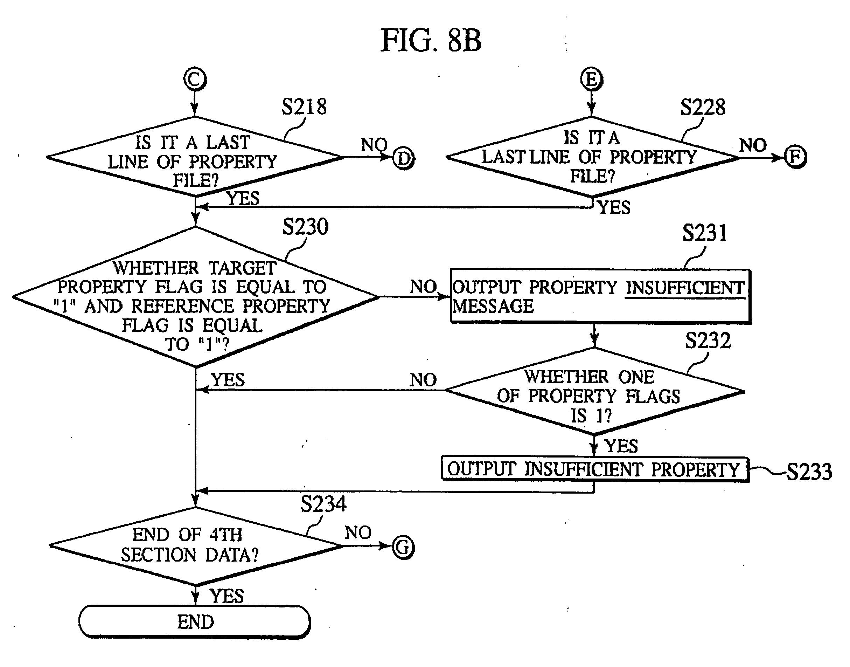

Next, corresponding to step S 12 shown in FIG. 5, a method for detecting and extracting property will be described with reference to FIG.8A and FIG.8B. The method for detecting and extracting property is to detect and to extract a property part including an interface signal between the controller (CON) 48 and the multiplier (MULT) 46, which are lower hierarchies (the second hierarchies) modules, from the signal list 40 stored in the data storage device 4. In this section, a method for extracting "CON.STB=>MULT.STB" from the signal list 40a of MULT 46 shown in FIG.7A and "MULT. Done=>CON.Done" from the signal list 40b of CON 48 shown in FIG.7B, as an interface signal between the MULT 46 and the CON 48, will be explained as a specific example.

(a) First, in step S201 shown in FIG.8A, the data storage device 4 is read. In step S202, data (inter-module connection information) of the fourth section is acquired from the data storage device 4. For example, data indicating signal connection relations shown in Figs 7A and 7B are read as data of the fourth section. Then, after the process of step S202, the processing proceeds to both step S210 and step S220.

(b) In step S210, a target property flag is set to "0". In step S220, a reference property flag is set to "0". Then, in step S211 and step S221, properties (targets) regarding a common terminal and properties (references) regarding a common terminal are respectively searched for the acquired data of the fourth section.

(c) Then, in steps S212 and S222, whether or not the properties concern the common terminal is determined. If the properties do not concern the common terminal, the process returns to step S211 and step S221 to start the next search. If the properties concern the common terminal, the processing proceeds to step S213 to set a target property flag to "1", and to step S223 to set a reference property flag to "1".

(d) In step S214 and step S224, a property file of a module corresponding to the properties concerning the common terminal, shown in FIG. 5A, is acquired. Then, from the acquired property file, in step S215 and step S226, one line is read from the acquired property files.

(e) In step S216 and step S226, whether or not a signal of the data of the fourth section is included is determined. If the data of the fourth section is included, the processing proceeds to step S217 and step S227, where a signal name is converted into a name of a top hierarchy to write the properties in the fifth section. For example, in the target side, "CON. STB=>MULT. STB" is extracted from the signal list 40a indicating an input connection relationship of MULT 46 shown in FIG. 7A. Then, "CON. STB=>MULT. STB" is converted into "{if{C0 (STB==1'b0)&&C1(forever(STB==1'b1)){(B=4'b 0000)=>C1(C11(D one));(B==4'b0001)=>C1(C12 (Done));..........}" shown in FIG. 5A, to be stored in the fifth section. Further, in the reference side, similarly for the signal of the controller (CON) 48 as shown in FIG.5B "MULT. Done=>con. Done" is converted into "{if{C0(RESETB ==1'b0)&&C1(forever (RESETB=1'b1)){(OP==2'b11)=>C2(STB==1'b0) &&C3 (forever(STB==1'b1);..........)" to be stored in the fifth section. If the signal of the data of the fourth section is not included in step S216 and step S226, and the processing proceeds to step S218 and step S228 shown in FIG.8B.

(f) In step S218 and step S228 shown in FIG.8B, whether or not the last line of the property file has been reached is determined. If the last line of the property file has not been reached, the process returns to steps S215 and S225 to respectively repeat the process from step S215 to step S218 or from step S225 to step S228. If the last line of the property file has been reached, the processing proceeds to step S230.

(g) In step S230, whether or not the target property flag is "1" and the reference property file is "1" is determined. If the target property flag is "1", and the reference property flag is "1", the processing proceeds to step S234. If the target property flag is "1", and the reference property flag is not "1", the processing proceeds to step S231, from which a property insufficient message is sent out, and the processing proceeds to step S232. Then, in step S232, whether or not one of the property flags is "1" is determined. If one of the property flags is not "1", the processing proceeds to step S234. If one of the property flags is "1", the processing proceeds to step S233, from which insufficient properties are sent out, and the processing proceeds to step S234.

(h) In step S234, whether or not the last of the data of the fourth section has been reached is determined. If the last of the data of the fourth section has not been reached, the process returns to step S202 to repeat the process from step S202 to S234. If the last of the data of the fourth section has been reached, the extraction of properties is ended.

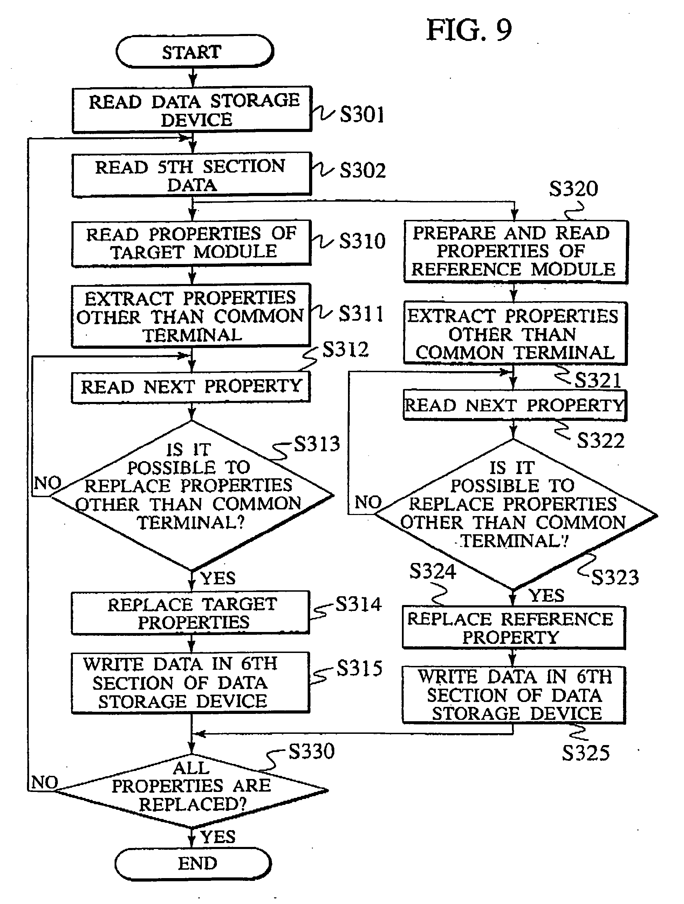

Next, corresponding to step S13 shown in FIG. 5, a process for extracting signal operation portions of properties, defining an output operation in the output side modules of each signals and an expected operation in the input side modules of each signal from signal properties between the modules extracted in step S12 will be described with reference to FIG.9.

(a) First, in step S301, data is read from the data storage device 4, and in step S302, the data of the fifth section is read out from the data storage device 4. Then, after the processing of step S302, the processing proceeds to both step S310 and step S320.

(b) In step S310, properties of the target module are read, and in step S320, properties of the reference module are read. In the first embodiment of the present invention, properties of the MULT 46 shown in FIG.4A are read as the properties of the target module, and properties of the CON 48 shown in FIG.4B are read as properties of the reference module.

(c) In step S311 and step S321, data other than that of the common terminal is extracted. Then, in each of step S312 and step S322, next properties are read.

(d) In step S313 and step S323, whether or not the data other than that of the common terminal can be replaced is determined. If the data other than that of the common terminal cannot be replaced, the process returns to step S312 and step S322, where the next properties are read. If the data other than that of the common terminal can be replaced, the target properties and reference properties are replaced in step S314.

(e) In step S315 and step S325, replaced data of the target and reference properties are stored in the sixth section of the data storage device 4. Then, in step S330, whether or not the replacement of all the properties has finished is determined. If the replacement of all the properties has not finished, the process returns to step S302 to repeat the processes from step S302 to step S330. If the replacement of all the properties has finished, the property operation extraction is ended.

A specific example for processes in step S324 shown in FIG.9 will be described as follows. For example, as shown in FIG.2, focusing an attention to a termination signal (Done), it is noticed that the output side is the MULT 46 and the input side is the CON 48. When a starting signal (STB) is focused, the output side is the CON 48, and the input side the MULT 46. In other words, when the termination signal (Done) is focused, a side of the MULT 46 generates the termination signal (Done). Therefore, a left side of the properties of the MULT 46 becomes a condition for generating the termination signal (Done). In this case, the left side includes the starting signal (STB) and a signal B. However, since the signal B is not inputted to the CON 48. Therefore, properties for the target side become "CO(STB==1'b0)&& C1(forever(RESETB==1'b1))=>C1(within 15 (Done))" when a correlation between the CON 48 and the MULT 46 is considered.

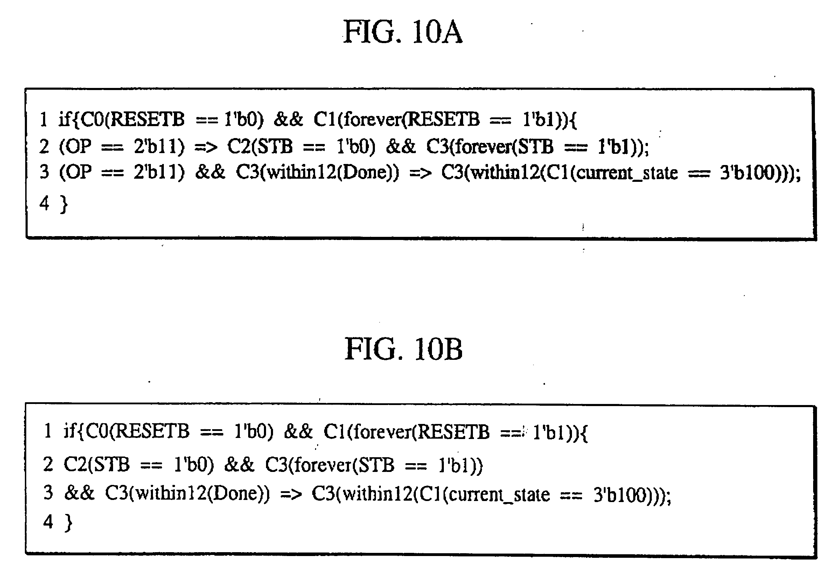

On the other hand, as shown in FIG.4B or FIG. 10A, a property of the CON 48 is "if{C0(RESETB==1'b0) && C1(forever(RESETB==1'b1)){(OP==2'b11)&&C3 (within 12 (Done))=>C3 (within12(C1(current_state ==3'b100)));}". However, "(OP==2'b11)" is proved as " (OP==2'b11)=>C2(STB==1'b0)&&C3(forever (STB==1 'b1));" in FIG.10A. Therefore, by substituting "C2 (STB==1'b0)&& C3(forever (STB==1'b1))" for "(OP== 2'b11)", the properties can be converted into "if{Co(RESETB==1'b0)&&C1(forever(RESETB==1'= b1)){C2(STB==1'b0)&& C3(forever(STB== 1'b1)&&C3 (within 12 (Done))=>3(within 12 (C1(current_state ==3'b100)));)" as shown in FIG.10B.

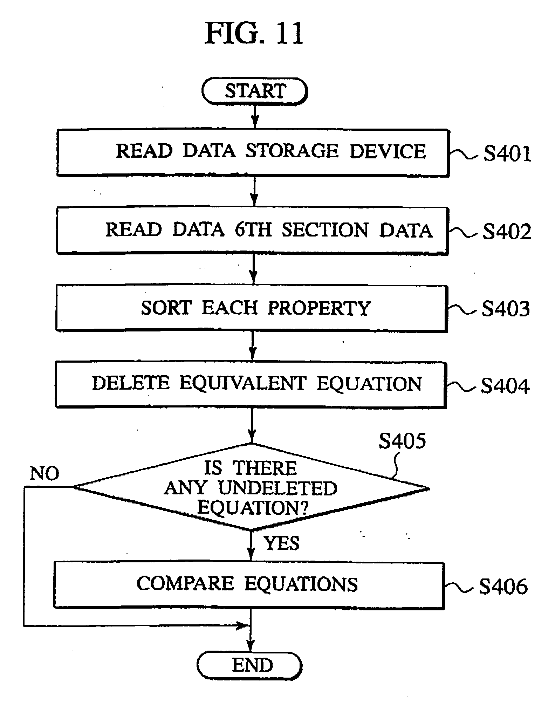

Corresponding to step S15 shown in FIG.5, a process for comparing properties of the MULT 46 and the CON 48 will be described with reference to FIG.11.

(a) First, in step S401, data of the data storage device 4 is read. Then, in step S402, properties of the sixth section of the data storage device 4 are acquired. Then, in step S403, the respective properties are sorted, and in step S404, equivalent equations are deleted. For example, by deleting the equal equations (or proved equations) from the properties of the CON 48, such as
"if{C0(RESETB==1'b0)&&C1(forever(RESETB==1'b1)){C2(STB==1'b0)&& C3(forever(STB==1'b1)&&C3(within 12 (Done))=>C3(within 12 (C1(current_state==3'b100)));)",
shown in FIG.10A,
it becomes
"C0(STB==1'b0)&&C3((forever(STB==1'b1))&&C1(within12(Done))." This converted and shortened equation means that a case where the starting signal (STB) is changed from "0" to "1", and the termination signal (Done) is asserted within 12 cycles. In a similar way, when the property of the MULT 46 is converted, the property becomes
"C0(STB==1'b0)&&C1(forever (STB==1'b1)=>C1(within 15 (Done))", which means that after the starting signal (STB) is changed from "0" to "1", the termination signal (Done) is asserted within 15 cycles.
(b) Then, in step S405, whether or not there is any undeleted equation is determined. If there are no undeleted equations, the comparison process is ended. If there are undeleted equations, the equations are compared with one another in step S406. For example, in method 1 of the first embodiment of the present invention, the property of MULT 46, "C0(STB==1'b0)&&C1(forever(STB==1'b1)=>C1(within 15 (Done))" is compared with the property of CON 48.
"C0(STB==1'b0)&&C1(forever(STB==1'b1))&&C1(within 12 (Done))" in step S406, and proceeds to process in step S16 in FIG.5.

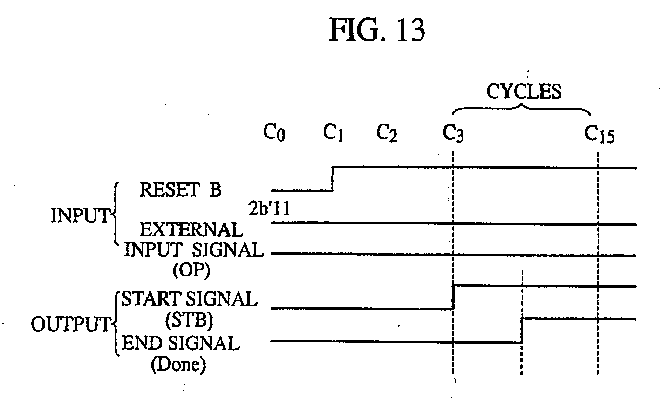

Next, corresponding to step S16 shown in FIG. 5, a description will be made of an embodiment when there is mismatch between properties, with reference to FIG.5 and FIG.13.

(a) First, corresponding to step S16, whether or not conditions of the properties match is determined. If the conditions match, the processing proceeds to step S18 in FIG.5. However, if the conditions do not match or mismatch, processing proceeds to step S17 in FIG. 5. For example, a number of cycles, used as a condition for the properties of CON 48, until the termination signal (Done) is asserted, may not satisfy a number of cycles of MULT 46, from the view of MULT 46 which actually generates the termination signal (Done). In other words, in the MULT 46, after the starting signal (STB) is changed from "0" to "1", the termination signal (Done) is asserted within 15 cycles. In the CON 48, however, CON 48 is not yet ready for receiving since a case where the termination signal (Done) is asserted within 12 cycles after the starting signal (STB) is changed from "0" to "1" is assumed, if the termination signal (Done) is asserted within 13 to 15 cycles in the MULT 46 side. If the CON 48 assumes a case where the termination signal (Done) is asserted within 16 cycles, it means that the CON 48 has extra space for the MULT 46. Such a case will be described in detail in a method 2. If the operations are consistent, in step S409, whether or not the operations are for hierarchical design is determined. The process from step S409 to step S414 will be described in method 2.
(b) Corresponding to step S17 in FIG.5. the report generator 17 generates and outputs mismatch report, and the display unit 20 displays a relation between the starting signal (STB) and the termination signal (Done) in a waveform as shown in FIG.13 when the mismatch detector 16 detects mismatches between the properties of MULT 46 and CON 48. For example, the description shown in FIG.10B indicates that the starting signal (STB) becomes "0" after two cycles and the starting signal (STB) becomes "1" after three cycles when the external input signal (OP) is "11". When this is displayed in a waveform, the starting signal of an output side shown in FIG.13 is "0" from C0 to C2, and "1" at C3.

## METHOD 2: DELETING A REDUNDANT PORTION

Next, a process for deleting a redundant portion when a redundant portion is determined in step S21 shown in FIG.5 will be explained with reference to FIG. 13A and FIG.13B. FIG. 13A and 13B show an example of properties for single verification of a MULT 46 and a CON 48 used in method 2 of the first embodiment of the present invention. Since limitation that is "an external input B is 3 or lower" is added, "B<=4'b0011" is further added as a specification of a top hierarchy 45.

(a) As in the case of method 1, corresponding to steps S11 to S12 of FIG. 2, in a process from step S101 to step S136 of Figs. 6A and 6B, a signal list 40 indicating a connection relation of signals between modules from a top hierarchy to a lower hierarchy (second hierarchy) is formed. In method 2, the signal list 40 indicating a connection relation of signals among three modules of a lower hierarchy, i.e., a MULT 46, a CON 48, and an ALU 47, is made to be stored in a data storage device 4.
(b) Note that in method 2, a relation between the MULT 46 and the CON 48 will be examined comparatively in processes from step S201 to step S234. FIG. 7A shows an input connection relationship of the MULT 46, and FIG. 7B is an input connection relationship of the CON 48.
(c) Then, in steps from S301 to S330 shown in FIG. 9, corresponding to step S13 in FIG.5, properties including an interface signal between MULT 46 and CON 48, which are lower modules (second hierarchy), are detected and extracted. In this process. "CON.    STB=>MULT.    STB",    and    "MULT. Done=>CON. DONE" are extracted. Focusing on these extracted signals, properties with relation to the termination signals (Done) are extracted from single verification properties (Figs. 13A and 13B) of the MULT 46 and the CON 48 properties. Note that in method 2, all the properties of both of the MULT 46 and the CON 48 are targeted. Further, in step S13, signal operation portions of properties defining an output operation in the output side modules of each signals and an expected operation in the input side modules of each signals are extracted from signal properties between the modules extracted. In other words, in method 2 of the present invention, in regards to the termination signal (Done), the output side is the MULT 46, and the input side is the CON 48. For a starting signal (STB), the output side is the CON 48, and an input side is the MULT 46. Further in step S13, properties including signals relating to both the MULT 46 and the CON 48 are extracted to be stored in the data storage device 4. In other words, single verification properties 20c and 20d of MULT 46 and CON 48, respectively similar to those shown in Figs. 13A and 13B, are extracted.

(d) In steps from S313 to S314, and steps S323 and S324 of method 1, a left side of the single verification properties of the MULT 46 shown in FIG. 13A becomes a condition for generating the termination signal (Done) since the MULT 46 side generates an termination signal (Done). The left side of the MULT 46 side includes a starting signal (STB) and a signal B. However, the signal B is not inputted to the CON 48. Considering a correlation between the CON 48 and the MULT 46, properties of the MULT 46 become

"C0(STB==1'b0)&&C1(forever(STB==1'b1)=>C1 (within 13 (Done)))". On the other hand, for the termination signal (Done), the CON 48 is an input side. Therefore, a single verification property of the CON 48 side is

"if{C0(RESETB==1'b0)&&C1(forever(RESETB==1'b1)){(OP==2'b11)&&C3 (within 15 (Done))=> C3(within 15(C1(current_state==3'b 100)));}" as shown in FIG. 13B. However, because "(OP==2'b11)" has been already proven by " (OP==2'b11)=>C2 (STB==1'b0)&&C3 (forever (STB==1'b1));" shown in FIG. 13B. Therefore, by substituting "C2(STB==1'b0)&& C3(forever (STB ==1'b1))" for "(OP==2'b11)". the properties may be converted into

if{C0(RESETB==1'b0)&&C1(forever(RESETB== 1'b1)){C2(STB==1'b0)&&C 3(forever(STB==1'b1) &&C3(within 15 (Done))=>C3(within 15 (C1(current_state==3'b100)));)".

Next, corresponding to step S15, in processes from step S401 to step S414 of FIG. 11, property comparison is carried out between the multiplier (MULT) 46 and the controller (CON) 48. The process from step S401 to step S407 is similar to that of method 2, the differences will be briefly described.

(a) First, in step S401, data of the data storage device 4 is read and properties of the sixth section are acquired from the data storage device 4 in step S402. Then, in step S403, the respective properties are sorted and equivalent equations are deleted in step S404.

(b) Then, in step S405, whether or not the equations, which have not been deleted, exist is determined. If there are no undeleted equations, the comparison is finished. If there are undeleted equations, in step S406, the equations are compared with one another. For example, in method 2 of the first embodiment of the present invention, the properties

"C0(STB==1'b0)&&C1(forever(STB=='1b1)=>C1 (within 13 (Done)))" of the MULT 46 side are compared with the properties

"C0(STB==1'b0)&&C1(forever(STB==1'b1))&&C1 (within 15 (Done))" of the CON 48 side in step S406.

(c) In step S16 shown in FIG. 5, whether or not the operations are consistent is determined. If the operations are not consistent, mismatch information is outputted to finish the comparison in step S17. If the operations are consistent, the processing proceeds to step S18, where whether or not there is any extra space within the specification is determined. If there is no extra space within the specification, the process is finished. If there is any extra space within the specification, the processing proceeds to step S19, where whether or not the operations are for hierarchical design is determined. If the operations are not for hierarchical design, information of a redundant portion is outputted in step S21 and the process is finished. In other words, it can be understood that in the case of method 2, the number of cycles until the termination signal (Done) is asserted, which is used as a condition for the properties of the CON 48 side, satisfies the number of cycles of the MULT 46 when seen from the MULT 46 side that actually generate the termination signal (Done). In other words, in the MULT side 46 side, after the starting signal (STB) is changed from "0" to "1", the termination signal (Done) is asserted within 13 cycles. In the controller (CON) 48 side however, since a case where the termination signal (Done) is asserted within 15 cycles after the starting signal (STB) is changed from "0" to "1" is assumed, it is known there is room. At this time, for a redundant portion of 2 cycles seen from the MULT 46 side, which processing to be executed thereon is displayed on a screen for a user. Accordingly, depending on a determination of the user, deletion of the redundant portion can be automatically executed.

## METHOD 3: INSERTING A REGISTER

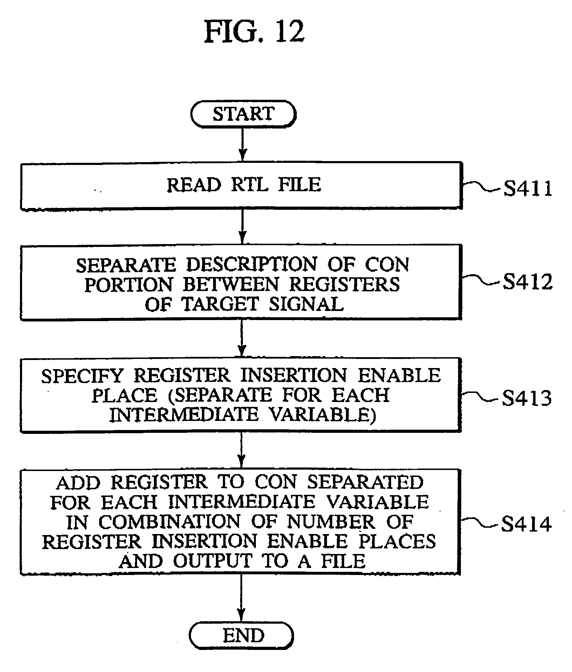

Next, corresponding to step S20 shown in FIG. 5, a method and a process for inserting a register to redundant portions when there are two cycles of a redundant portion within CON 48 with reference to FIG.12. The process from step S411 to step S414 is similar to that of method 2, the differences will be briefly described in method 3.

(a) Corresponding to step S19 shown in FIG.5, when hierarchically designing CON 48, proceeds to step S20. First, in step S411 in FIG.12, a RTL file is read. In this step S411, a flip-flop circuit (F/F) must be inserted into an input/output of a hierarchical boundary to facilitate delay calculation in processing after logic synthesis.

(b) In step S412, description of the CON 48 is separated from the space between registers of target signals. Then, in step S413, a place for inserting a register is specified by separating each intermediate variable.

(c) In step S414, a register is added to the CON 48 separated for each intermediate variable in a combination of the numbers to be able to insert registers, and output to a file. Then a process for comparison is ended.

For the termination signal (Done) that is an input of the CON 48, the redundant portion of 2 cycles has been determined to exist by timing of specified cycles of the Done circuit top in the process 4. Thus, no logical problems occur even if the flip-flop circuit is inserted immediately after the input. Therefore, depending on the determination of the user, the flip-flop circuit can be inserted immediately after the termination signal (Done) in the CON 48.

According to the first embodiment of the present invention, by making a list of connection relation between hierarchies, properties regarding inter-hierarchy interface are extracted from properties (group) independently prepared in the lower hierarchy (second hierarchy), thus enabling a hierarchical property checking method. In addition, by converting properties into target inter-hierarchy interface signals considering a limitation on external inputs, an operation of transferring inter-hierarchy signals can be clearly defined. Moreover, according to the first embodiment of the present invention, a plurality of properties regarding target signals are integrated, and optimized to clearly define the operation of transferring inter-hierarchy signals.

Further, according to the first embodiment of the present invention, inter-hierarchy properties are compared to detect mismatch in interface portions. Thus, by using properties independently prepared for each lower hierarchy, the interface of the top hierarchy can be verified to carry out verification for a large circuit. Moreover, according to the first embodiment of the present invention, since omitted properties can be detected, the quality of the property checking method can be improved. In addition, according to the first embodiment of the present invention, when properties are omitted, by using properties of a module to be connected, and using them as a base for preparing additional properties, the efficiency of the property checking method can be increased.

Still further, according to the first embodiment of the present invention, the specifying mismatched places is facilitated by displaying mismatched interface between hierarchies in a waveform. In addition, according to the first embodiment of the present invention, since inter-hierarchy properties are compared to detect mismatch in interface portions, by using properties independently prepared for each lower hierarchy, the interface of the top hierarchy can be verified to carry out verification for a large circuit. Further, according to the first embodiment of the present invention, in the case of carrying out hierarchical design, register insertion into the hierarchy boundary to facilitate delay calculation in processing after logic synthesis can be surely executed without incursion of any defects. Moreover, according to the first embodiment of the present invention, redundant portions in specifications can be deleted with certain and without the incursion of any defects, thus enabling the productivity of high-quality circuit description.

## SECOND EMBODIMENT

## - CONCEPTUAL DIAGRAM OF LSI DESIGN VERIFICATION APPARATUS

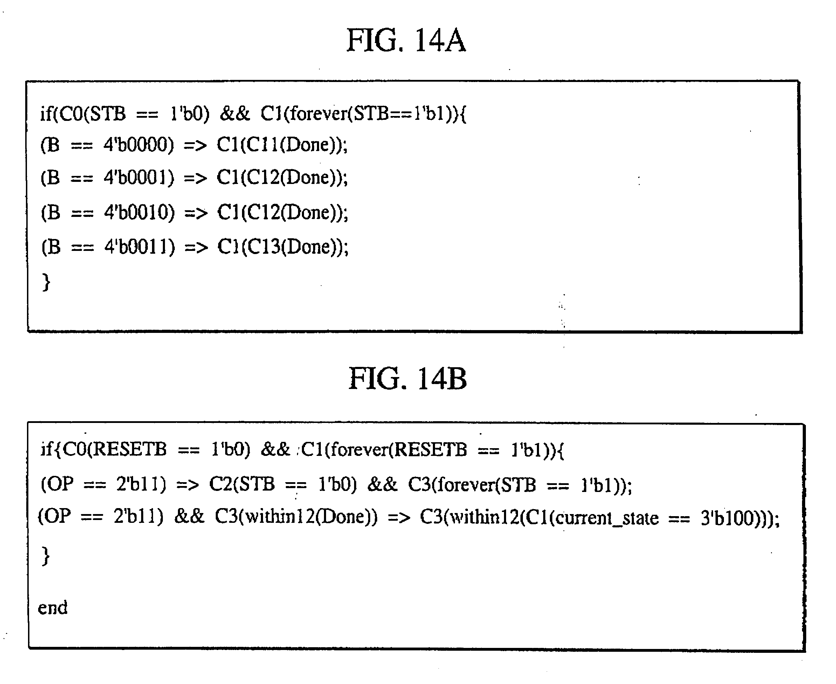

FIG. 14 shows a conceptual diagram showing an LSI design verification method according to a second embodiment of the present invention. An integrated simulation environment 80 shown in FIG. 14 includes top test bench description (language for verification) 68 in logical simulation, driving test bench description (language for verification) 61 in the logical simulation, expected value checking test bench description (language for verification) 67 in the logical simulation, and top testing model description (HDL) 64 of a verification target module. When a verification target is a module T, first, the verification target module T is analyzed from model description M(TOP) of a top module to obtain an input connection relation (C(I)) of model description of a module I (M(I)) 60 that gives an input to the verification target module T, and an input connection relation (C(T)) of the verification target module T. The driving test bench description 61 is generated based on property description (property language) 62 of the module I that gives an input to the verification target module T. The checking test bench description 67 is generated based on property description (property language) 66 of the verification target module T. The top test bench description 68 is includes the driving test bench description 61, and the checking test bench description 67. The top testing model description 64 is generated from model description 63 of the verification target module T. Further, the model description 63 reports inactivation codes by a report 65.

## - ARCHITECTURE OF LSI DESIGN VERIFICATION APPARATUS

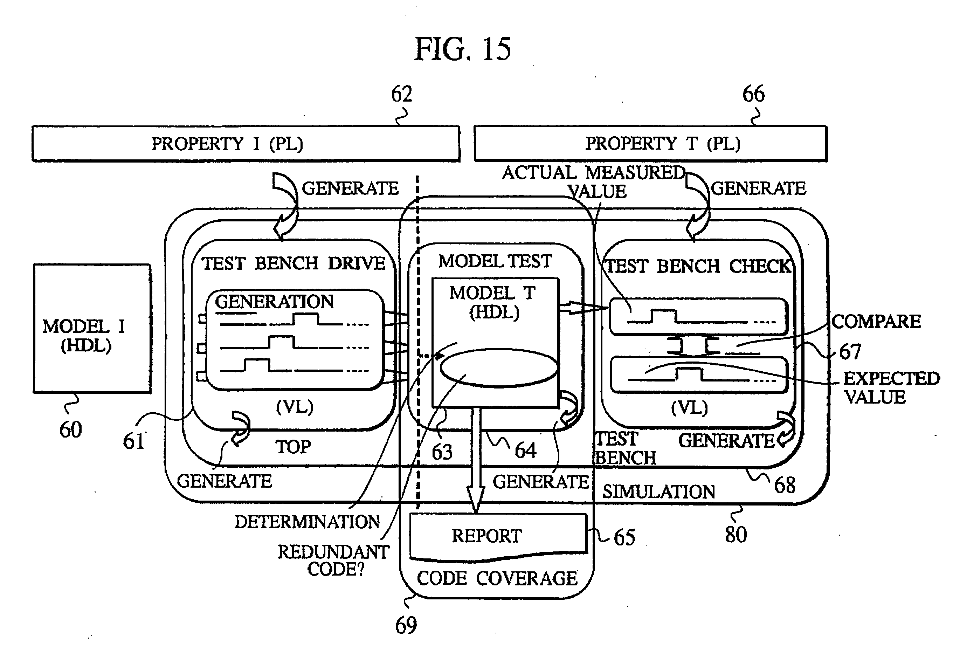

An LSI design verification apparatus 1 according to the second embodiment of the present invention shown in FIG. 15 comprises, as described above with reference to the first embodiment of the invention, at least a central processing unit (CPU) 2, an input device 31 and an output device 32 connected through an input/output control device 33 to the CPU 2, a data storage device 4 connected to the CPU 2 and a main memory 35. As in the case of the first embodiment, the CPU 2 is provided with a database management unit for which the drawing is omitted.

The CPU 2 includes at least a circuit description reading unit 10, an analysis unit 11, a property generation unit 21, a driving test bench generation unit 22, a checking test bench generation unit 23, a top test bench generation unit 24, a top model generation unit 25, a logical simulation unit 26, a code coverage measurement unit 27, and an automatic determination unit 28.

The circuit description reading unit 10 reads a circuit description of an experimental circuit in the LSI design verification apparatus 1. The analysis unit 11 analyzes a connection relation and a signal input/output relationship between modules from a top hierarchy, for the read circuit description. The property generation unit 21 generates property description includes a signal connected to a verification target module from a property description that gives an input to the verification target module. The driving test bench generation unit 22 generates a test vector from the property description, and driving test bench description to be inputted. The checking test bench generation unit 23 generates a checking test bench description for comparing an output in simulation with an output in specifications from the property description of the verification target module. The top test bench generation unit 24 generates top test bench description for a top hierarchy from the driving test bench description and the checking test bench description to execute these in parallel. The top model generation unit 25 generates top model description for simulation that becomes an interface with the model description of the verification target module. The logical simulation unit 26 performs logical simulation in the simulation environment including the driving test bench description, the checking test bench description, the top test bench description, and the top model description. The code coverage measurement unit 27 executes code coverage measurement. The automatic determination unit 28 automatically determines whether or not an inactivation code reported by the code coverage measurement can be activated in specifications based on the property description of the module that gives an input to the verification target module.

## - SPECIFICATION OF EXPERIMENTAL CIRCUIT

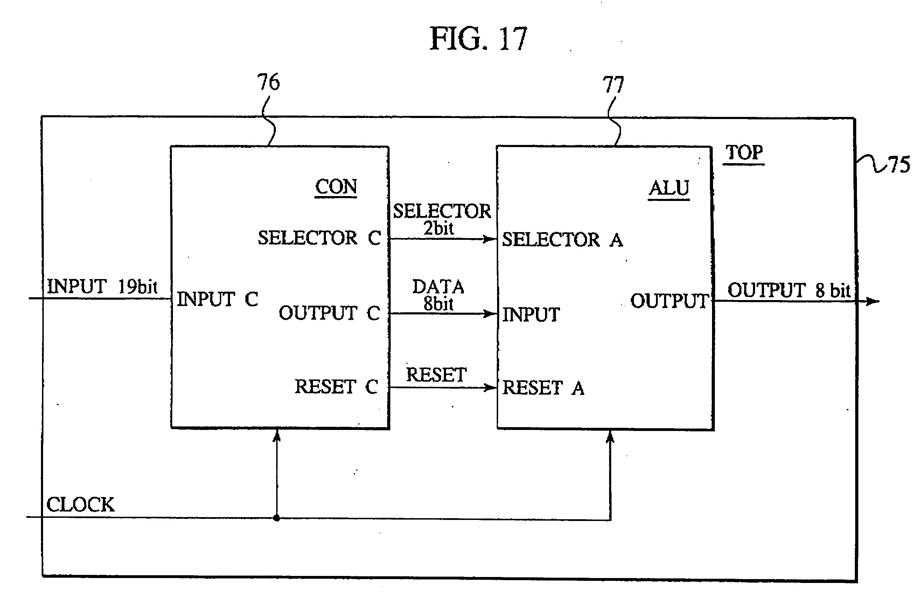

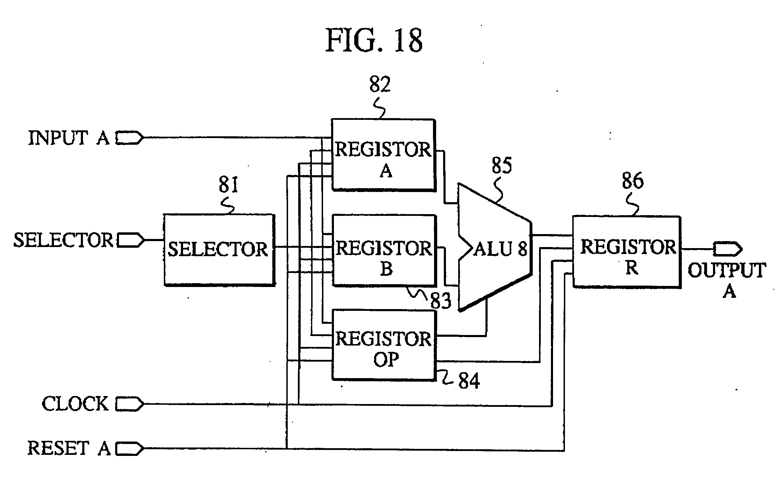

Next, description will be made of specifications of an experimental circuit used in the second embodiment of the present invention by referring to FIG. 17 and FIG. 18. FIG. 17 is a circuit diagram of the experimental circuit used in the second embodiment of the present invention. FIG. 18 shows a module constitution in the experimental circuit ALU used in the second embodiment of the present invention.

The experimental circuit used in the second embodiment of the present invention comprises a top hierarchy (TOP) 75, and a controller (CON) 76 and an arithmetic logic unit A(ALU) 77 which includes a second hierarchy (lower hierarchy). Hereinafter, description is made of a method for automatically generating a simulation environment to check a logical function of model description M(ALU) by using the LSI design verification method of the second embodiment of the present invention. This is the case when the above-described verification module T is the ALU 77, and the existing module I to become an input to the module T is the CON 76.

From model description M(TOP) 59 of a top hierarchy, based on a result of analyzing a connection relation between modules, the following signal input/output relations (a) to (c) are analyzed.

(a) As shown in FIG. 17, an input signal (IN) having 19-bit data, and a clock signal (CLK) are inputted to the model description M(TOP) 59 of the top hierarchy, and an output signal having 8-bit data is outputted. Here, the input signal (IN) includes 8-bit data A and B, and a 3-bit external input signal OP (operator information). The external input signal (OP) can be subjected to a logical operation of "AND", "OR", "EX-O", "addition or subtraction", or setting to "0". When the input signal (IN) is inputted, the data A and B are arithmetically operated by the external input signal (OP), and the result of the arithmetic operation is outputted to the output signal (OUT).

(b) Then, an input signal C (CIN) having 19-bit data and a clock signal (CLK) are inputted to the parallel input serial output converter (CON) 76 of a lower hierarchy (second hierarchy). An output signal C (COUT) having 6-bit data, a selector C (CSEL) having a 2-bit command, and a reset signal C (CRESET) are also outputted. The CON 76 has two internal states, i.e., an empty state and a full state. (i) In the case of the empty state, the input signal C (CIN) is distributed to a register A (8 bits), a register B (8 bits), and the external input signal OP (operator information) (3 bits) to set a full state. (ii) In the case of the full state, signals are outputted in the following sequence:

CRESET=1 -> CRESET=0 -> CRESET=1, CSEL=00, COUT-A -> CSEL =01, COUT=B -> CSEL=10, COUT=OP,

and after the output of the signals in this sequence, the process returns to the empty state.

(c) Then, an input signal A (AIN) including 8-bit signal, a 2-bit command selector A (ASEL), a resent signal A (ARESET), and a clock signal (CLK) are entered to the sequential input (ALU) 77 of the lower hierarchy (second hierarchy), and an output signal A (AOUT) is outputted. First, the input signal A (AIN) is stored in each of the registers A (8 bits) and B (8 bits), and the external input signal OP (operator information) (3 bits) depending on a value of the command selector A (ASEL). That is:

when "ASEL=2'b00" is set, the input signal A (AIN) is stored in the register A, when "ASEL=2'b01" is set, the input signal A (AIN) is stored in the register B, when "ASEL=2'b10" is set, the input signal A (AIN)"2:0" is set in the external input signal OP (operator information); Second, after a value is stored in the external input signal OP (operator information), an operation OP is executed for the data A and B, and a result is outputted to the output signal A (AOUT) on the next cycle. By the external input signal OP (selector A (ASEL)), AND (000), OR (001), EX-O (010), addition (011), subtraction (100), 0 output (others) are changed; Third, after the reset signal A (ARESET) is asserted, all the registers are set to 0.

## - LSI DESIGN VERIFICATION METHOD

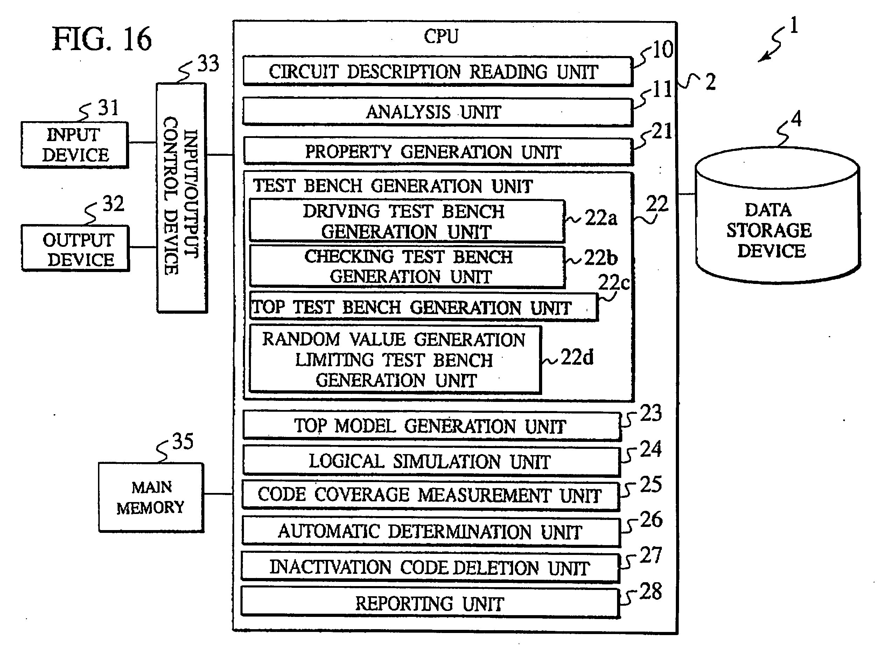

The design verification method of the second embodiment of the present invention will be explained with reference to FIG.16.

(a) First, in step S31, the analysis unit 21 analyzes a circuit description from model description M(TOP) 59 of a top module to analyze a module hierarchical structure. In addition, the analysis unit 21 also analyzes what signal is present between modules, which module the signal is outputted from, and what module it is entered to. When a given module that outputs an input signal of a verification target module T is a module I, an input connection relation (C(I)) 69(a) of the module I and an input connection relation (C(T)) 69(b) of the module T are obtained.
(b)Then, in step S32, from property description P(I) 62 of the module I, property description (P(I->T) 74 including the signal, whose output is an input to the verification target module T, is extracted.
(c) Then, in step S33, the driving test bench generation unit 22a generates driving test bench description T(drive) 61 from the property description (P(I->T)) 74 extracted in step S32.
(d) In step S34, when property description P(T) 66 of the verification target module T is present, the checking test bench generation unit 22b generates checking test bench description T(check) 67, comparing an output value in an integrated simulation environment 80 with an output expected value in an interface specification, based on the property description P(T) 66. When the property description P(T) 66 of the verification target module T is not present, a user manually inputs a description checking test bench description T(check) 67.
(e) In step S35, the top test bench generation unit 22c generates a top test bench description T(TOP) 68, which concurrently executes the driving test bench description T(drive) 61 and the checking test bench description T(check) 67. The top test bench generation unit 22c also generates a simulating top model description M(TEST) 64, which becomes an interface with the model description M(T) 63 of the verification target module T. Then, the top test bench description T(TOP) 68, the driving test bench description T(drive) 61, the checking test bench description T(check) 67, and the simulating top model description M(TEST) organize the integrated simulation environment 80.
(f) In step S36, in the integrated simulation environment 80, a random seed value (SEED), which becomes a source for a collection of generated random values, is set to execute a logical simulation targeting the model description M(T) 63 of the module T. Simultaneously, code coverage measurement of the model description M(T) 63 of the module T is executed.
(g) In step S37, by using the checking test bench description T(check) 67, whether or not an output value in the integrated simulation environment 80 and an output expected value in specifications match is determined. If mismatch between the output value in the integrated simulation environment 80 and the output expected value in specifications is reported within the checking test bench description T(check) 67, the user corrects the HDL description by referring to an error report 65a in step S38. If matching between the output value in the integrated simulation environment 80 and the output expected value in specifications is reported within the checking test bench description T(check) 67, the processing proceeds to step S39.
(h) In step S39, whether or not an inactivation codes present in the code coverage report 65b is determined. If the determination in step S39 shows no presence of inactivation codes, the process is finished there. If the determination in step S39 shows presence of an inactivation code, the processing proceeds to determination of step S40.
(i) In step S40, whether or not there is any possibility for activation in the specification from the property description P(I) 62 of the module I obtained in step S32. If the activation in specifications is determined to be impossible, the inactivation code is deleted in step S 41, and after a line number of the deleted inactivation code is reported as a deletion report 70, simulation is re-executed from step S36.

(j) If there is a possibility for activation, whether or not there is any possibility for activation with in the interface specification in step S42. When there is no possibility for inactivation in step S42, the processing proceeds to step S43. In step S43, the test bench description T(drive-cst) 71 for limiting random value generation is generated to activate the code, and the process returns to step S31. If there is a possibility of inactivation in step S42, the processing proceeds to step S44. In step S44, determination is made as to inactivation of the inactivation code. If the code is activated, the processing proceeds to step S45.

(k) In step S45, if possibility of activation cannot be determined in step S44, whether or not any activated codes exist is determined within the inactivation codes of the previous simulation of step S36. If there are not any new activated codes, the process is finished there. If there are some new activated codes, test bench description (T(drive-cst)) 71 for limiting random value generation, which increases the number of test patterns (NUM). is generated, the random seed value (SEED) is changed to generate a new random seed value 72, a new NUM value (number of test patterns) 73 is generated, and simulation is executed again from step S36. If the previous inactivation code is not activated in step S44, the process is finished.

## METHOD 1:

Next, a method for above described LSI design verification method of the second embodiment of the present invention will be described with reference to FIG. 16 to FIG. 38.

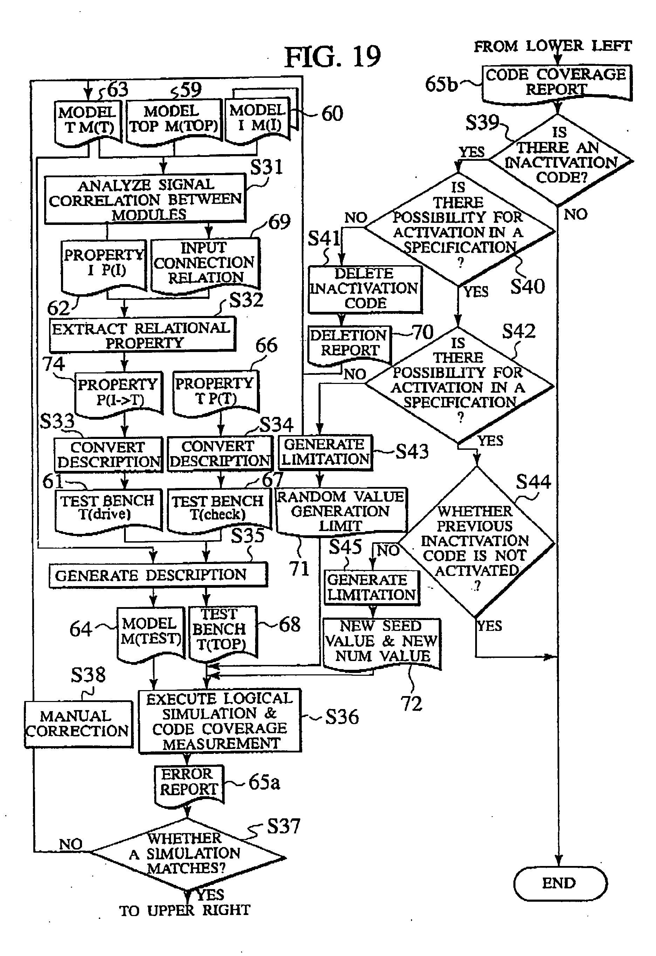

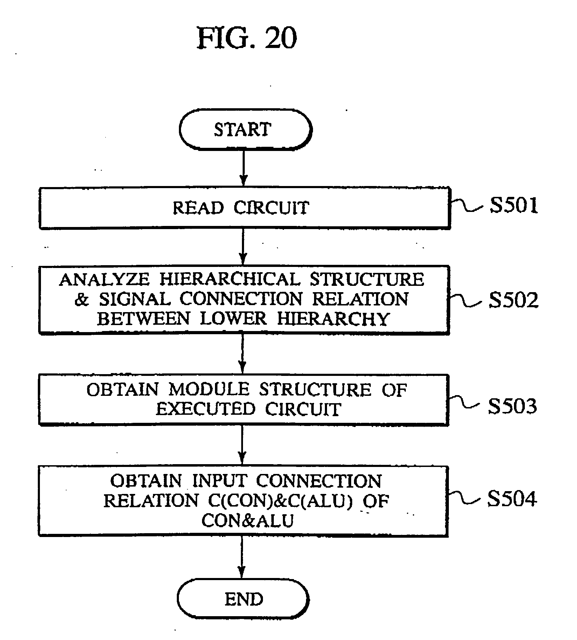

First, details of the step S31 shown in FIG. 19 will be described with reference to FIG.20.

(a) In step S501 shown in FIG.20, a circuit description is read from model description M(TOP) 59 of a top module. Then, a hierarchical structure of the circuit module and a signal connection relation between lower hierarchies (second hierarchies) are analyzed in step S502.

(b) After a module structure of the executed circuit is obtained in step S503, an input connection relation C(I) 69a of a module I and an input connection relation C(T) 69b of a module T are extracted in step S504. In other words, in the following description, the input connection relation C(I) 69a of the module I is extracted as an input connection relation (CON) of the CON, and the input connection relation C(T) 69b of the module T is extracted as an input connection relation (ALU) of the ALU.

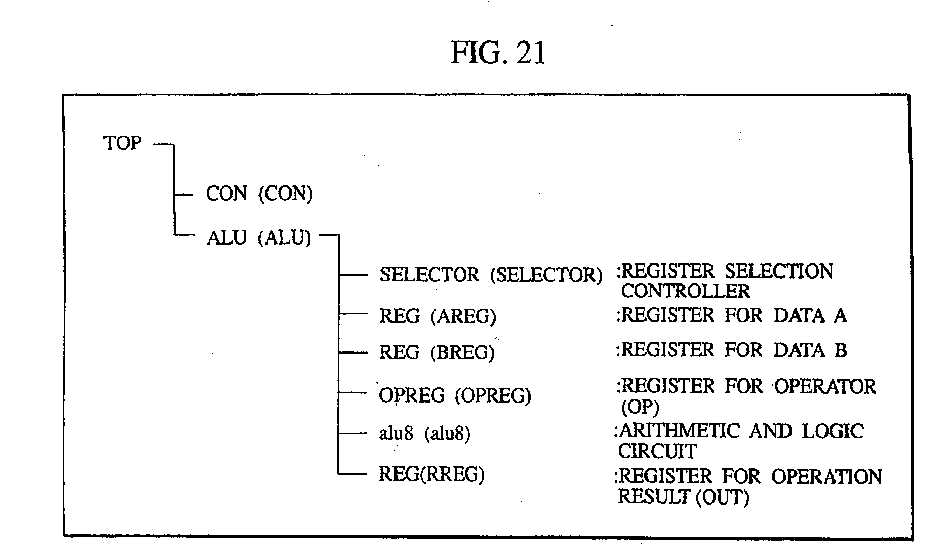

A module structure of an executed circuit according to the second embodiment of the present invention is shown in FIG.21. In the module structure shown in FIG. 21, a module name is written on a left side of a bracket, and an instance name in HDL description in the bracket, for example "module name (instance name in the HDL description)". As shown in FIG. 21, a top circuit TOP 75 includes a controller (CON) 76, and an arithmetic logic unit (ALU) 77. The ALU 77 has a register selection controller (SELECTOR), a register for holding data A (AREG), a register for holding data B (BREG), a register for holding operator OP (OREG), an arithmetic logic circuit (alu8), and a register R for holding an operation result OUT (RREG).

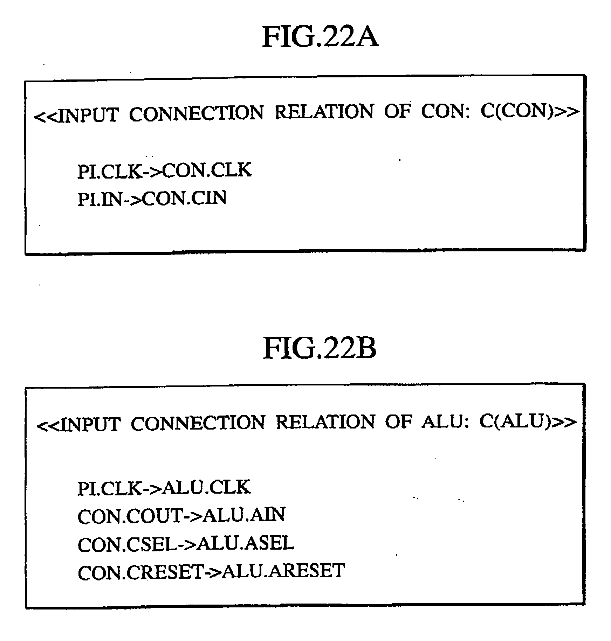

An input connection relation C(CON) of the controller (CON) 76 is shown in FIG.22A, and an input connection relation C(ALU) of the ALU 77 is shown in FIG.22B. In the input connection relation C(CON) of the CON 76 shown in FIG. 22A, an external input signal PI. CLK indicates a signal CON.CLK of the CON 76, and an external input signal PI.IN indicates an input signal CON.CIN of the CON 76. In the input connection relation C(ALU) of the ALU 77 shown in FIG. 22B, an external input signal PI.CLK indicates a signal ALU.CLK of the ALU 77, an output signal CON.COUT of the CON 76 indicates an input signal ALU.AIN of the ALU 77, a signal CON.CSEL of the CON 76 indicates a signal ALU.ASEL of the ALU 77, and a reset signal CON.CRESET of the CON 76 indicates a resent signal ALU.ARESET of the ALU 77.

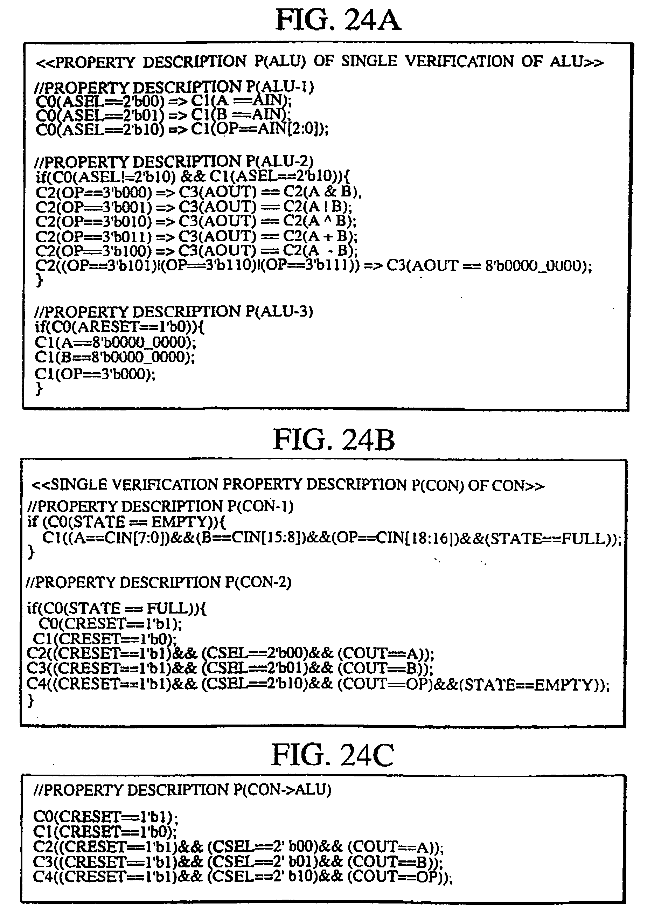

Second, details of the property description used in step S32 shown in FIG.19 will be described with reference to FIG.24A, FIG.24B, and FIG.24C. The property description of a module T, P(T) 66. is described as a property description for a single verification P(ALU) of the module ALU 77, shown in FIG.24A, in the following description. In addition, the property description of a module I, P(I) 62, is described as a property description for a single verification P(CON) of the module CON 76, shown in FIG.24B, in the following description.

The property description for the single verification P(ALU) of the module ALU 77 includes property descriptions P(ALU-1), P(ALU-2) and P(ALU-3) for verifying the operations (i), (ii) and (iii) of the ALU 77 in an interface specifications of the executed circuit described above.

In the property descriptions, the register A of the ALU 77 must be described in a form of TOP.ALU. AREG.out, for example, since description must be made in accordance with a hierarchical structure of a real circuit. However, for simplification, the resister is simply represented by A. In addition, in FIG. 24A to FIG. 24C, "n" of "Cn" denotes "after n cycles". For example, in description of

"C0(ASEL==2'b00)=>C1(A==AIN), "C0" denotes "after 0 cycle", and "C1" denotes "after 1 cycle".

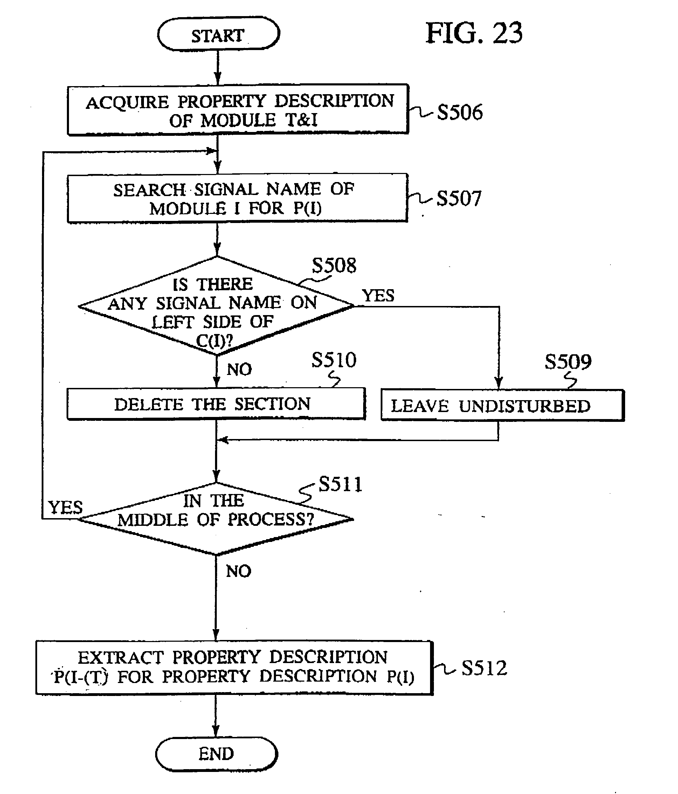

Then, corresponding to step S32, a method for extracting relational property will be explained with reference to FIG. 23.

(a) In step S506, the property description P(T) 66 of the module T, and property description P(I) 62 of the module I are acquired. Then, the property description P(T) 66 of the module T, and the property description P(I) 62 of the module I are described below respectively as single verification property description P(ALU) of the module ALU 77, and single verification property description P(CON) of the module CON 76.

(b) A property description P(I->T) 74 having a signal regarding the module T, is extracted for the property description P(I) 62 of the module I. Since the property description P(I->T) 74 is obtained in the following processes from step S508 to step S512. In step S507, for the property description P(I) 62, an output signal name of the module I is searched (i.e., an output signal name of the CON 76 is searched for the property description P(CON) shown in FIG. 23B.)

(c) In step S509, for the searched signal name, determination is made as to presence of the signal name on the left side of the input connection relation C(T) 69 of the module T obtained from step S501 to step S504. If the signal name is not present on the left side, in step S511, the section thereof is deleted. If the signal name is present, in step S510, the state thereof is maintained. (i.e., for the searched signal name, if the signal name is not present on the left side of the input connection relation C(ALU) of the arithmetic logic unit (ALU) 77 shown in FIG. 22B, the section thereof is deleted, and if present, the section is maintained intact.)

(d) When the processing is in a middle of a description, searching is continued for returning to the process from a subsequent line. If the processing is at the end of the description, in step S512, for the property P(I), property description P(I->T) is extracted to end the processing. When the described processing is applied to the property description P (CON-1) and the property description P(CON-2) shown in FIG. 23B, the property description P (CON-1) is totally deleted, and property description P(CON->AKU) shown in FIG. 23C is obtained from the property description P(CON-2).

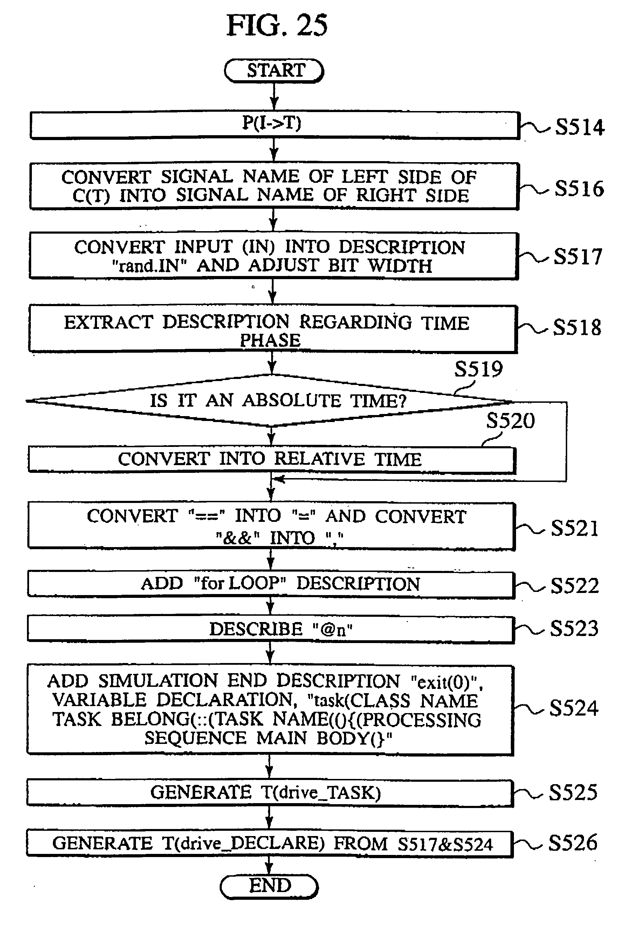

Third, corresponding to step S33 in FIG.19, a driving test bench T(drive) 61 is generated from the property description P(I->T) 74, which is P(COM->ALU) in FIG.23C, with reference to FIG. 25 from step S514 to S526. The test bench description includes a task section and a class declaration section. Accordingly, the driving test bench description T(drive) 61 includes a driving task section test bench description T(drive_TASK) 61a and a driving class declaration section test bench description T(drive_DECLARE) 61b. In the task section, a substantial processing sequence is described. The drive_TASK 61a is obtained by executing the processes from step S514 to S526 to the property description P(I->T) 74.

(a) In step S514 of FIG. 25, the property description P(I->T) is acquired.

(b) In step S516, a signal name of the left side of the input connection relation C(T) 69b of the module T is converted into a signal name of the right side. In other words, a signal name of the left side of the input connection relation C(ALU) of the module ALU shown in FIG. 22B is converted into a signal name of the right side.

(c) In step S517, an input signal (IN) to the module T, for which a value has not been fixed, is converted into description "rand.IN", to which a random generation value is allocated. In this case, a bit width is adjusted. In other words, the input A(AIN) to the ALU 77 is converted into "rand.IN" and the bit width is adjusted.

(d) In step S518, description regarding a time phase is extracted. Then, in step S519, whether or not the extracted time phase description is absolute time is determined. If the description is absolute time, the absolute time is converted into relative time in step S520. If the extracted description regarding the time phase has already been set in the determination of step S519, the processing proceeds to step S521.

(e) In step S521, other than in a conditional statement, "==" for representing comparison of a sample value of a DUT (circuit to be verified) with an expected value is converted into "=" for representing driving, and "&&" is converted into ",". For example, in the property description P(CON->ALU) obtained in the processing A, "C2((ARESET==1'b1)&& (ASEL==2'b00)&&(AIN==rand.A));" in the processing of the description "C2((CRESET==1'b1)&& (CSEL==2'b00)&&(COUT==A));" is converted into "C2((ARESET=1'b1),(ASEL=2'b00),(AIN=rand. A));".

(f) In step S522, a "for loop" description for repeatedly entering a sequence of a series of test patterns is added. At this time, the number of repeated times is set to NUM. In addition, in step S523, the process must wait for an input of a next test vector until the end of the comparison of the checking section. In addition, it is described that "@n" means to wait for n cycles. In other words, "C2" in the "C2((ARESET=1'b1),(ASEL=2'b00),(AIN=rand.A));" obtained in step S521, is converted here into "@1". Then, "@n" is added at the end of the description.

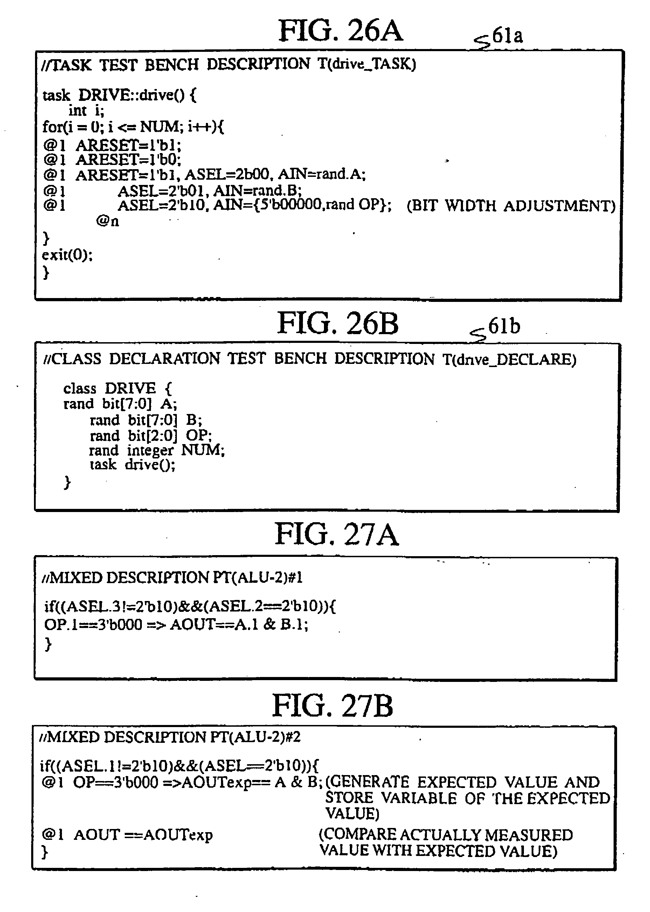

(g) In step S524, simulation end description "exit (0)", variable declaration, task block description "task<class name to which task belong to>::<task name>( ){<processing sequence main body>}" are added. If the above processing B, from steps S514 to S524, is applied to method 1 of the second embodiment of the present invention, driving task section test bench description T(drive_TASK) 61a shown in FIG. 26A is obtained in step S525.

(h) In step S526, driving class declaration section test bench description T(drive_DECLARE) 61b is generated. In the class declaration section, variable declaration and task declaration are described. A variable allocated to a random generation value is declared not in the task, but in the class declaration. A variable name of the variable declaration is obtained from the processing B, and a declaration name of the task declaration is obtained in step S524. By applying the above processing to the embodiment of the second embodiment of the present invention, driving class declaration section test bench description T(drive_DECLARE) 61b shown in FIG. 26B is obtained.

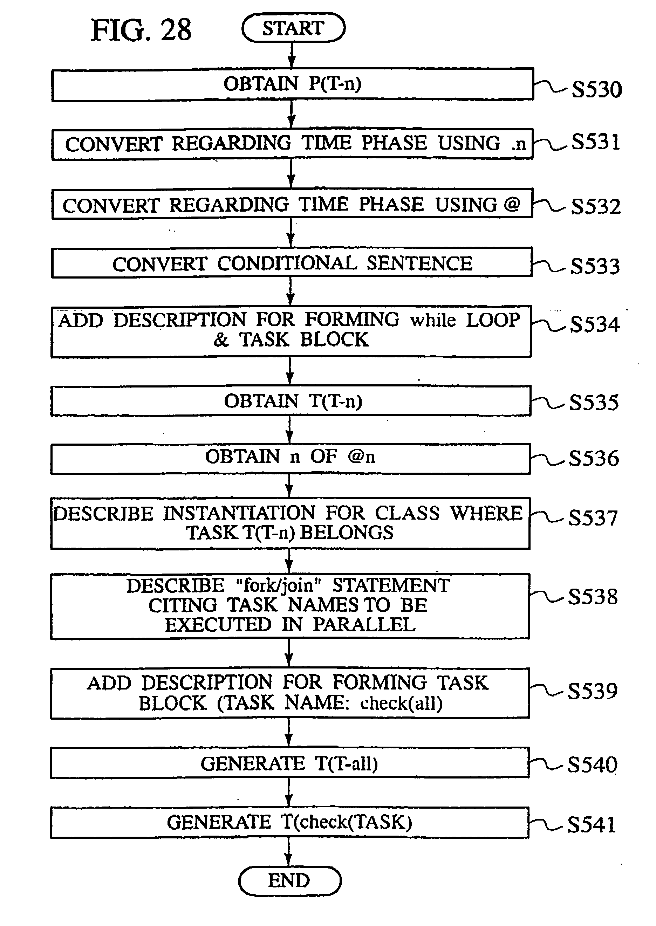

Fourth, corresponding to step S34 shown in FIG.19, generation of the checking test bench description T(check) 67 will be explained with reference to FIG. 28.

As in the case of the driving test bench description T(driver) 61, the checking test bench description T(check) 67 includes a checking task section test bench description T(check_TASK) 67a and a checking class declaration section test bench description T(check_DECLARE) 67b.

The checking task section test bench description T(check_TASK) 67a, generated before the checking test bench description T(check) 67 is generated, includes a property checking test bench description T(T-n), which is obtained by converting the property description P(T-n) of the module T, and a concurrent processing test bench description T(T-all), for executing all the forgoing tasks in parallel.

Thus, in order to generate the checking task section test bench description T(check_TASK) 67a, the property checking test bench description T(T-n) is generated. A comparative checking for comparing an output value and an expected value of a DUT (a circuit to be verified) within the test bench descriptions is achieved by "==" in other than a conditional statement, and reported errors. Then, the simulation is ended.

These property checking test bench description T(T-n) is generated by applying the processes in step S530 to S541 shown in FIG.28 to each of the property description P(T-n). The processes in the step S530 to S541 will be described with reference to FIG.28.

(a) In step S 530 shown in FIG.28, the property description P(T-n) is acquired. Then, in step S531, the property description P(T-n) is converted by using a time phase ".n". With in the test bench description, a signal value of DUT of the past is possible to be sampled, but a signal value of the future is difficult to be sampled. Therefore, the reference (current time) is shifted to a time phase of the future value. Since C3 becomes a reference in P(ALU-2), shown in FIG.24A, C3 becomes the reference. Therefore, executing the process of step S531, a mixed description PT(ALU-2)#1 shown in FIG.27A is acquired, and the value of the signal before n cycles is represented by "signal.n" within the test bench description.

(b) In step S532, conversion is carried out regarding a time phase using @. For the "signal.n" in the test bench description, an amount of memory consumption is larger as n gets larger since a value before n cycles must be held. Therefore, a description "@n", advancing the n cycle time, is used for the conversion. In this case, in a statement "AOUT==A. 1&B.1" in FIG. 26A, variable AOUTexp is declared since the left side time and the right side time is different, and the description is divided by using this declaration. However, in the case of "OUT= IN. 1", the amount of memory consumption is not changed even if the following is set:

pre_IN= IN

@1 OUT=pre_IN.

Therefore, no conversion is carried out in such a case.

(c) By applying the process of step S532 to the mixed description PT(ALU-2)#1, shown in FIG.27A, a mixed description PT(ALU-2)#2 is acquired. In other words, when the process of step S532 is proceeded to a statement, "OP.1==3'b000=>AOUT ==A.1&B.1;" shown in FIG.27A, the mixed description PT(ALU-2)#1 is converted into "@1OP== 3'b000=>AOUTexp==A&B;" for generating the expected value and storing a variable of the expected value.

(d) Then, the statement is further converted into "@1 AOUT==AOUTexp", shown in FIG.27B, for comparing an actually measured value with the expected value.

The processes of step S531 through step S532 are applied to all of the operation information OP, and all of the operation information is converted in step S533 and step S534.

(e) In step S533, a conditional statement is converted. First, the left side of "=>(imply description" of the property description is converted into an if statement of test bench description. Further, for all the external input signals OP (operator information), the conditions are not simultaneously established since time phase and registers are identical, and the conditions can be connected by "an if/else_if statement" or "a case statement". By executing the processing of step S533 for the mixed description PT(ALU-2)#2 shown in FIG. 26B, task section test bench description T(ALU-2) shown in FIG. 28A can be acquired.

(f) In step S534, description for forming a while loop and a task block is added. First, a loop statement is added. Since the end of simulation is controlled by the driving test bench description T(drive) 61, "while (1)" for forming an endless loop is used here, and loop processing is finished by forced termination executed at the driving side. Further, if variable declaration, and description for forming a task block are added, property checking test bench description T (T-n) is obtained in step S535.

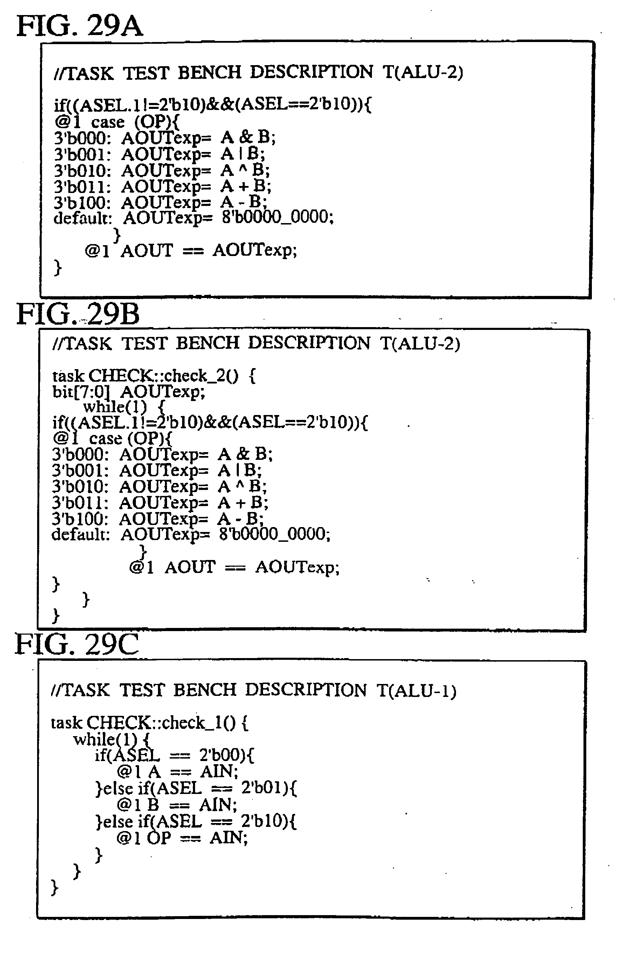

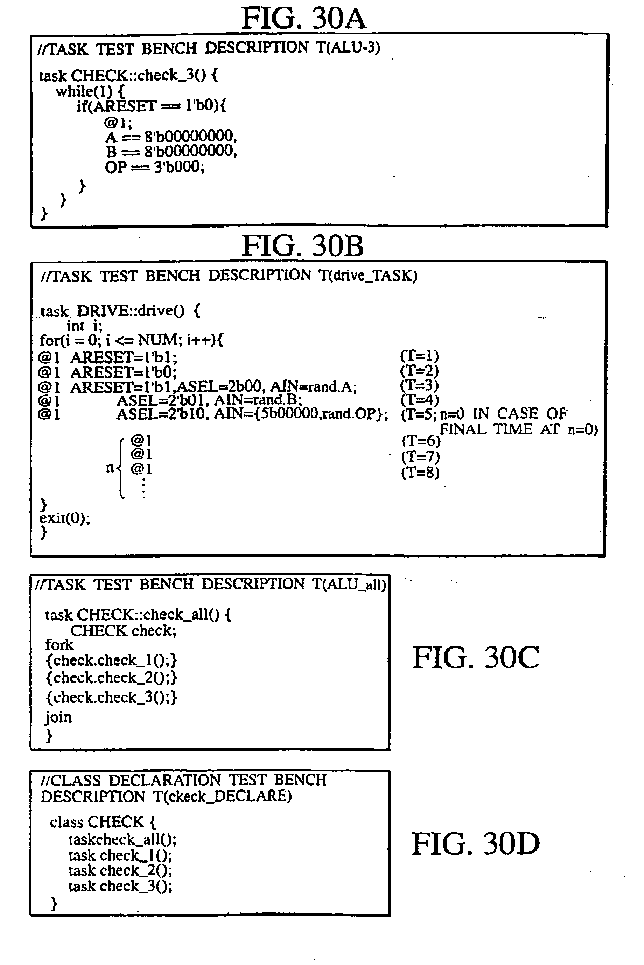

(g) By executing the processing of step S534 for the checking task section test bench description T (ALU-2) shown in FIG. 29A, the checking task section test bench description T(ALU-2) shown in FIG. 29B can be obtained. Similarly, by applying the above-described processing (in step S531 to step S534) for the property description P(ALU-1) shown in FIG. 24A, the checking task section test bench description shown in FIG. 29C can be acquired in step S535. In addition, by applying the above-described processing (in step S531 to step S534) for the property description P(ALU-3) shown in FIG. 24A, checking task section test bench description T(ALU-3) shown in FIG. 30A can be obtained in step S535.

(h) In step S536, "n" of "@n" in the driving test bench description T(drive) 61 (FIG. 26A and FIG.26B) obtained in step S530 to step S534 is evaluated. A code "n" denotes a difference between time regarding a case where the time for executing comparison "==" of each of the checking test bench description T(chck) is latest amongst times of the driving test bench description T(drive), and the last time in the case of "n=0" in the driving test bench description T(drive). For example, the time in the driving test bench description T(drive) 61 is described as (T=n) as shown on a right side row of the task section test bench description T(drive_TASK) 61a shown in FIG. 29B. At this time, in the checking task section test bench description T(ALU-1) shown in FIG. 28C, if ASEL==2'b00, T=4 is set, If ASEL==2'b01m, T=5 is set, if ASEL==2'b10, T=6 is set, T=7 is set in the case of T(ALU-2), and T=3 is set in the case of T (ALU-3). Because T-7 is latest, n=7-5=2 is set.

(i) Then, in a process of steps S537 to S539, concurrent processing test bench description T(T-all) is generated. In the concurrent processing test bench description T(T-all), the process of the step S537 to step S539 is executed to describe three items. First, in step S537, instantiation of a class, to which a task T(T-n) belongs, is described. Then, in step S538, a "fork/join" statement citing task names to be executed in parallel is described. Then, in step S539, description of forming a task block (task name:

check_all) is added. The above steps S537 to S539 are obtained from step S534 for obtaining each property checking test bench description T(T-n).

(j) By applying the process of the above step S537 to step S539, the test bench description T(T-all) shown in FIG. 29C is generated in step S540. In addition, by executing the process of the steps S530 to S540, the checking task section test bench description T(check_TASK) 61a including T(ALU-1), T(ALU-2), T(ALU-3), and T(ALU-all) can be generated in step S 534.

(k) Then, the checking class declaration test bench description T(check_DECIARE) 61b is generated. In the checking class declaration section since no random variables are used in the task section, task declarations are described. These declarations are obtained in step S534 for generating each property checking test bench description T(T-n), and from a current processing task name check_all.

(l) As described above, by applying the process of the steps S530 to S54, a checking class declaration section test bench description T(check_DECLARE) 61b shown in FIG. 30D can be generated in step S541.

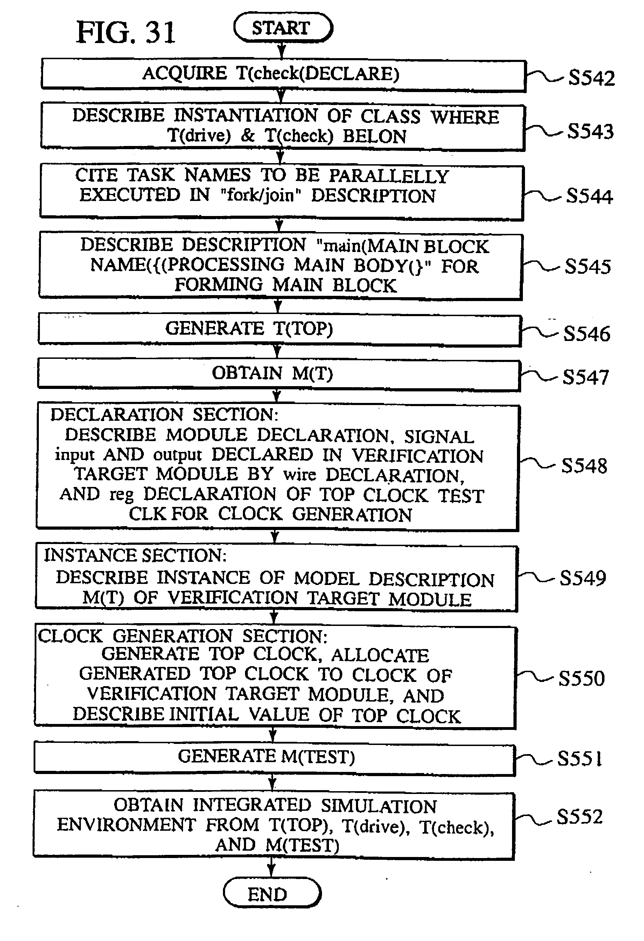

Fifth, corresponding to step S35 shown in FIG. 19, generation of the model description M(TEST) 64 and the test bench description T(TOP) 68 will be explained with reference to FIG.31. With in the step S542 through step S546, the driving test bench description T(drive) 61, the checking test bench description T(check) 67 are concurrently executed, and the top test bench description T(TOP) 68, which is positioned above the T(drive) 61 and T(check) 67, is generated.

(a) In step S31, shown in step S542, a top main section test bench description T(check_DECLARE) 67b is acquired. Then, in step S543, a class where T(drive) 61 and T(check) 67 exist is instantiated.

(b) In step S544, task names, which are executed in parallel, are cited by a "fork/join" description. Then, in step S545, a description "main<name of a main block>{<a body of a main process>}" is added for forming the description as a main block.

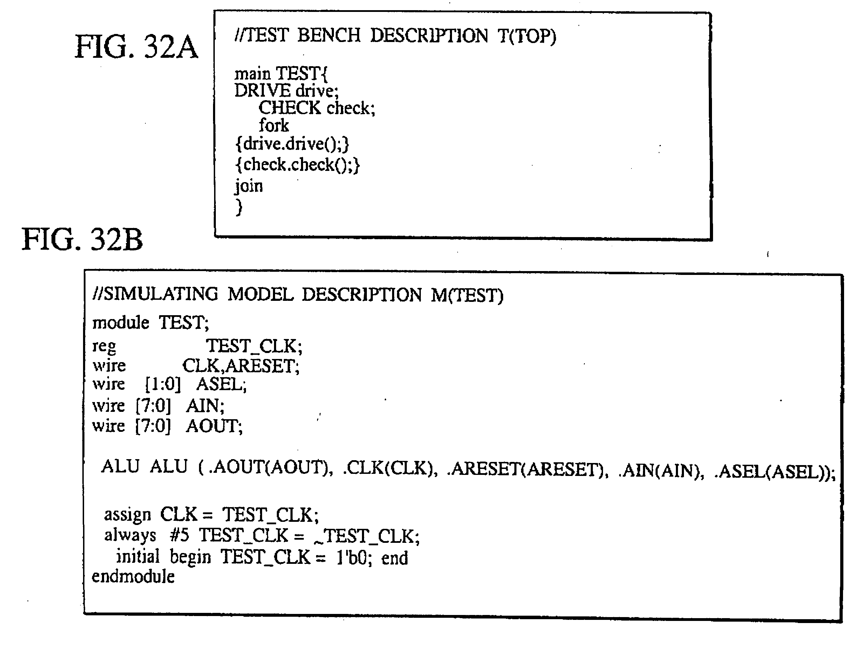

(c) In step S546, a op test bench description T(TOP) is generated by using a tope main section test bench description T(check_DECIARE) 67b shown in FIG.32A. A simulating top model description M (TEST) 64, which becomes an interface for the top test bench description T(TOP) 68 and the verification target module M(T) 63, is generated.

(d) In step S547, a model description M(T) 63 of the verification target module T is acquired. Then, in step S548, a wire declaration is made for signals declared as an input and output within the module declaration and the verification target module as a declaration section. Further more, a top clock TEST_CLK for generating a clock is described in a reg declaration.

(e) In step S549, an instance section describes an instance of the model description M(T) 63 of the verification target module. Further, in step S549, a clock generation section describes the generation of the top clock, the allocation to the verification target module clock of the top clock generated, and an initial value of the top clock. Then, in step S551, a simulating top model description M(TEST) is generated. The simulating top model description M (TEST) 64 obtained from model description M(ALU) of a verification target module ALU is shown in FIG. 31B.

(f) Lastly, in step S552, an integrated simulation environment 80 is acquired. The integrated simulation environment 80 includes the top test bench description T(TOP) 68, the driving test bench description T (drive) 61, the checking test bench description T (check) 67, and the simulating top model description M(TEST) 64.

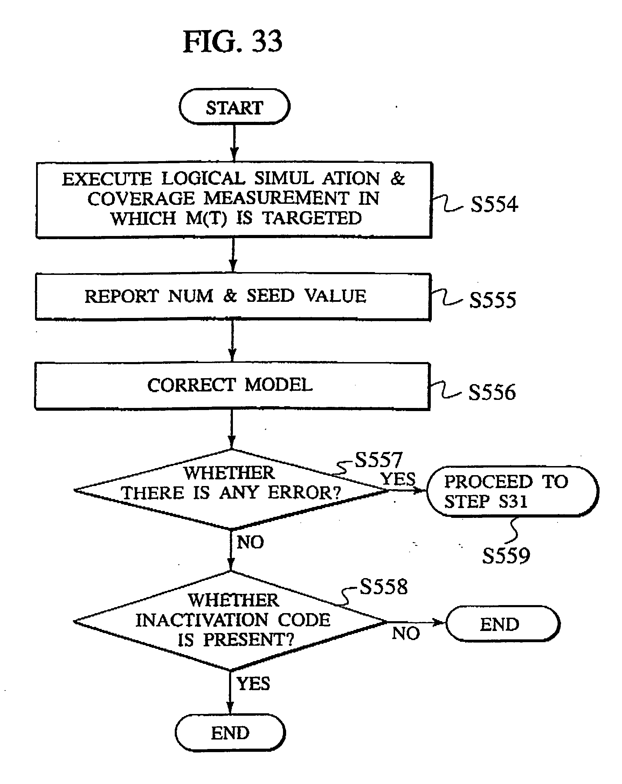

Sixth, corresponding to step S36 through step S39 in FIG.19, a process for executing a logical simulation will be described with reference to FIG.33.

(a) In step S554 shown in FIG. 33, a random seed value SEED is used for executing logical simulation and a coverage measurement. Then, in the integrated simulation environment 80, acquired in step S52, a logical simulation and a coverage measurement, which target the model description M(T) of the verification target module, is executed. Within the execution of the logical simulation and the coverage measurement, a test bench tool, a simulation tool and a code coverage tool are simultaneously used.

(b) In step S555, the NUM value and the random seed value SEED are reported. The random seed value SEED becomes a source of a value of a collection of random values, and the collection of the generated random values are changed by changing the value of the collection of the random values. While the random seed value SEED is maintained at a default setting value in the integrated simulation environment acquired in step S555, the logical simulation, targeting the model description M(ALU), and coverage measurement are executed.

(c) In step S556, the model description is corrected. Corresponding to the step S37 in FIG.19, in step S557, whether or not there are any errors in the model descriptions are determined. If there is any error, an error report 65 is reported, and the process returns to step S501 in FIG.19 to reprocess the processes in step S501 through step S504 until error reports are not reported. After a simulation regarding the model description M(ALU) of the verification target module ALU in step S557, where the M(ALU) is corrected and no more errors are reported, the processing proceeds to step S558.

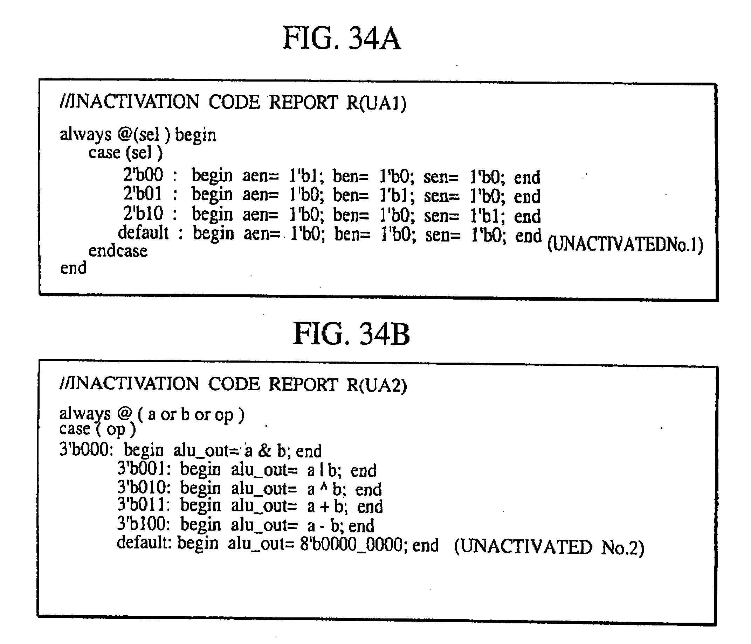

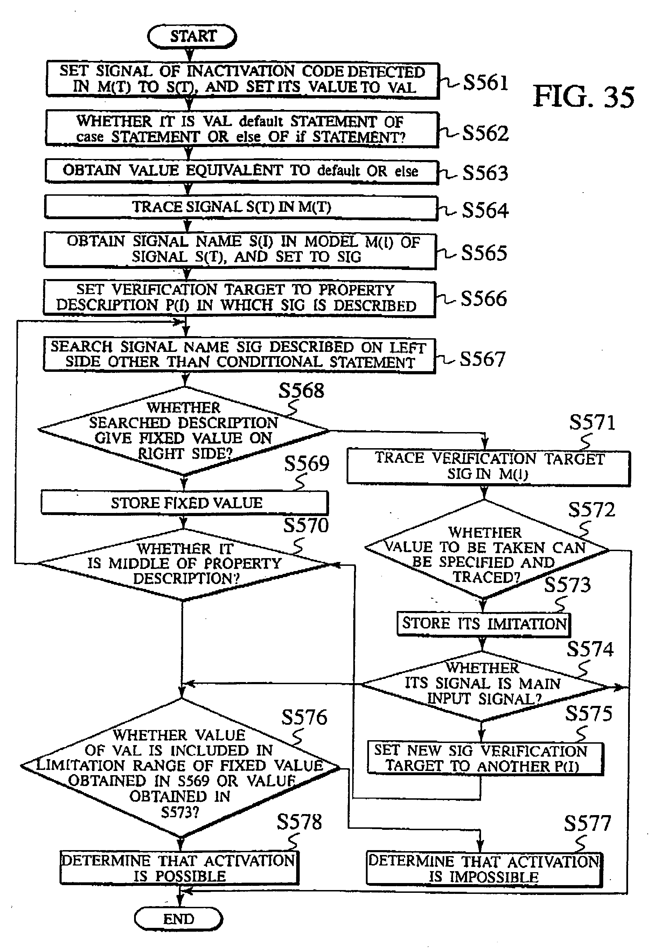

(d) In step S558, whether or not there is an inactivation code is determined. For example, the presence of the inactivation code is determined from the code coverage report shown in FIG.34A and FIG. 34B. From an inactivation code 1 shown in FIG.34A, it is determined that inactivation is reported at a "sel==default" value within a case block of a module selector under the verification target module. In addition, from an inactivation code 2 shown in FIG. 34B, it is determined that inactivation is reported at an "OP==default" value within a case block of a module alu8 under the verification target module. In this manner, a presence of an inactivation code is determined from the code coverage report in step S558, then the processing proceeds to step S560 in FIG.35.

Seventh, corresponding to step S40 in FIG.19, a process for determining whether or not there is any possibility for activating an interface specification from the property description P(I->T) acquired in step S512 will be described with reference to FIG.35.

(a) In step S561, a signal of the inactivation code detected in the model description M(T) 63 of the verification target module is set to S(T), and its value is set to VAL. Then, in step S562, determination is made as to whether or not the VAL is "default" of a case statement or "else" of an if statement, and a value equivalent to the "default" or the "else" is obtained in step S563. Then, in step S564, the signal S(T) is traced in the model description M(T) 63, and in step S565, a signal name S(I) of the signal S(T) in the description M(I) 60 is found and set to SIG. Then, in step S566, a verification target is set to the property description P(I) 62, in which the SIG is described.

(b) In step S567, the signal name SIG that has been described on a left side, other than a conditional statement, is searched for. In step S568, for the searched description, determination is made as to whether or not a fixed value has been given on a right side. If a fixed value has been given on the right side, in step S569, the fixed value is stored, and then the processing proceeds to step S570. If the determination in step S568 shows that a REG variable (register variable) has been given on the right side, the processing proceeds to step S571.

(c) In step S570, determination is made as to whether or not the processing is in the middle of the property description. If the processing is in the middle of the property description, the process returns to step S567, where searching is executed from a subsequent line. If the processing is at the end of the property description in step S570, the processing proceeds to step S576.

(d) In step S571, verification target SIG is traced in the model description M(I). Then, in step S572, whether or not a value taken by the signal can be specified for being traced is determined. If the signal can be specified for being traced, a limitation is stored in step S573. In step S574. determination is made as to whether or not the signal is a main input signal. If the signal is the main input signal, the process is finished. If the signal is not the main input signal, in step S575, a new SIG verification target is set to another P(I) 62, and the process returns to step S 570. If a value taken by the signal cannot be specified in step S574, "determination impossible" is set, and the process is finished.

(e) In step S576, whether or not the value VAL is included is determined in a limitation range of the fixed value obtained in step S569 and the value obtained in step S573. If the value VAL is included, it is determined as an activation is possible in step S578, and the process is finished. If the value VAL is not included, it is determined as an activation is impossible in step S557, and the process is finished.

## METHOD 2: APPLYING TO INACTIVATION CODES 1 AND 2

In a method 2, a method for applying an inactivation code 1 and an inactivation code 2, shown in FIG. 34A and FIG.34B, to the processes of step S561 through S578 in FIG.35 will be described.

(a) First, in step S561 through step S563, "S(T)=sel, VAL=2'b11" are set from an inactivation code report R(UA-1) shown in FIG.34. In step S564, a selector signal (sel) is traced in the M(ALU) to be set to "sel (module: SELECTOR)-(ASEL (module:ALU)." Further, in step S565, "S(I)=CSEL" is set from the C (ALU) obtained in step S504 of FIG. 19, thereby "SIG=CSEL" is set. Then, in step S566, a verification target is set to property description P(CON-2).

(b) Then, in steps S567 to S570, fixed values of "2'b00", "2'b01", and "2'b10" are stored, and the processing proceeds to step S576. In step S576, since "2'b11" of the value VAL is outside of the limitations of "2'b00", "2'b01", and "2'b10", it is determined as an activation is impossible in the interface specifications, and the process is finished.

(c) Next, a case for executing the determination of the inactivation code 2 is considered. In the above-described process of steps S561 to S563, "S(T)=op" and "VAL=3'b101, 3'b110, 3'b111" are set from the description R(UA-2). In step S564, a "sel" signal is traced in the M(ALU) to set "op(module:alu8)->OPOUT(module:ALU)->opout=ain[2:0](module:OPREG)->AIN(module:ALU)". Further, in step S565, "S(I)=COUT" is set from the C(ALU) obtained in step S504 of FIG. 19, thereby "SIG=COUT" is set. Then, in step S566, a verification target is set to property description P(COM-2).

(d) Then, the processes of step S567 to step S568 and step S571 to step S575 are executed, and property description P(CON-1) is searched from "COUT=OP(REG variable)". Then, in step S571, "OP=CIN[18:16](module:CON)" of a signal is traced. In step S572, an input signal C(CIN) is a main input, and a value to be taken is specified to 3 bits (3'b000 to 3'b111). Lastly, in step S576, since "3'b101", "3'b110", "3'b111" of the values VAL are included in "3'b000" to "3'b111", "activation possible in specifications" is determined in step S578, and the process is finished.

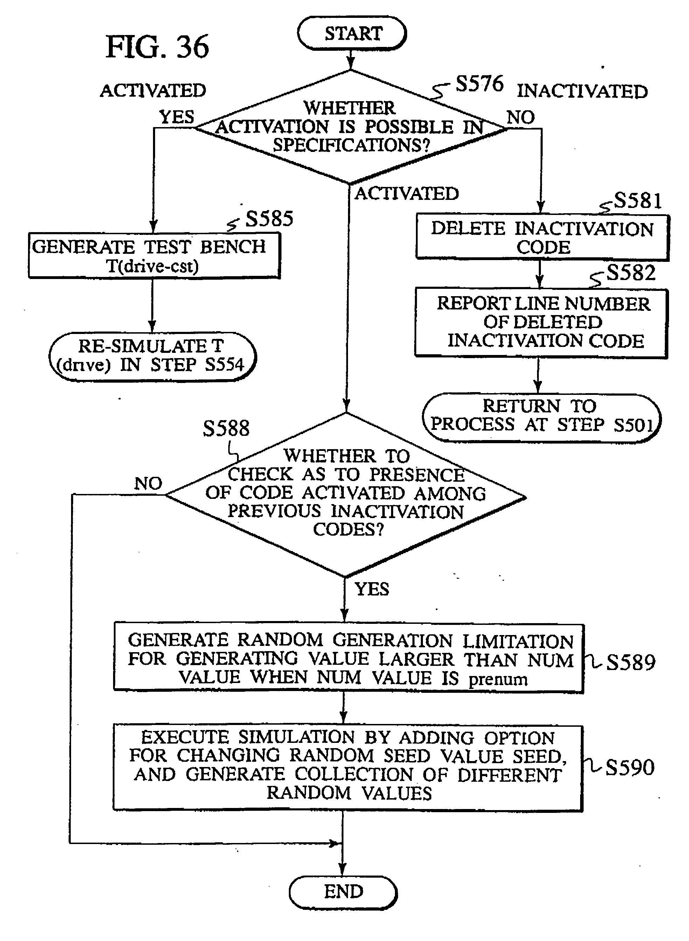

Next, corresponding to step S40 through step S45 in FIG.19, a process for determining whether or not there is any possibility for activating an interface specification from the property description P(U->T) will be described with reference to FIG.36.

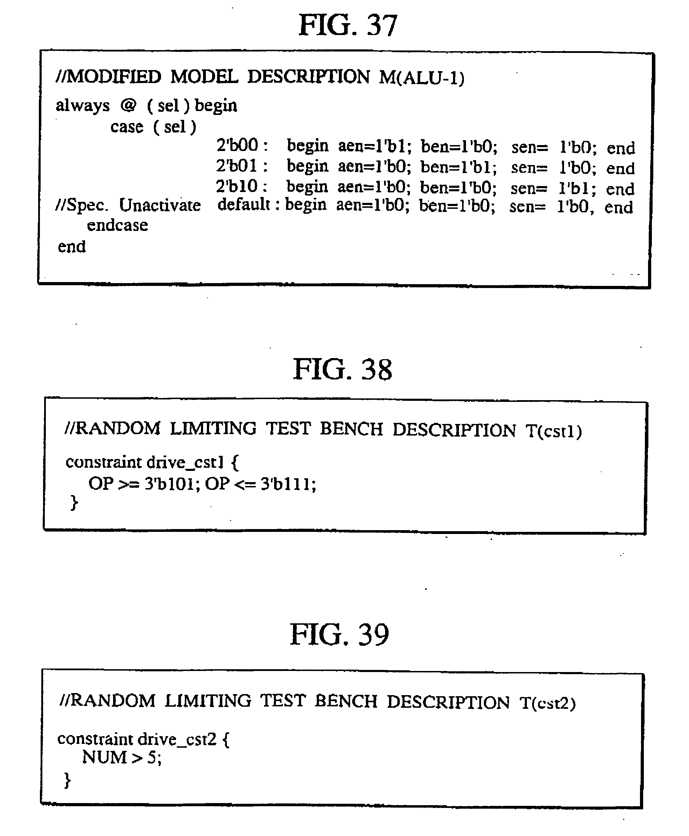

(a) First, in step S576, whether or not there is any possibility for activating an interface specification from the property description P(U->T) is determined. If it is determined that the activation is impossible in the interface specification, the inactivation code is deleted in step S581. Then, in step S582, a line number of the deleted inactivation code is reported, and the process goes back to the process in step S501 in FIG.20. For example, for the inactivation code 1 shown in FIG.34A, a default statement of the model description M(ALU-1) is determined as inactivated in the interface specification. Therefore, the default statement is invalidated by comment out "//" from the model description M (ALU-1). Then, deleted line number of the same file is reported in step S582, and the process goes back to step S501 in step S501. A modified model description M(ALU-1) is shown in FIG.37.

(b) If it is determined that the activation is possible in step S576, a random value generation limiting test bench description T(drive-cst), which activate the code, is generated in step S585. Then, the process returns to step S554 of FIG. 32, the test bench description T(drive-cst) is included in the driving test bench description T(drive) 61, and simulation is executed again. For example, for the inactivation code 2, it is determined that the default statement of the model description M(ALU-2) can be activated in the interface specifications, and a tracing result shows "3'b000<=OP<=3'b111". Therefore, a limiting test bench description is generated for generating a test vector to activate the default statement of the model description M(ALU-2). In addition, in the test bench description T(drive) 61, random generation limitations of "OP>=3'b101" and "OP<=3'b111" are added to a randomly generated OP value to obtain a random limitation test bench description T(CST1) 71a shown in FIG. 38 from "AIN={5'b00000,rand.OP"}. Further, the generation limiting test bench description T(CST1) 71a is included in the driving test bench description T(drive) 61, and simulation is executed again.

(c) In a case that determining whether or not a code can be activated is impossible in step S576, the presence of an activated code that was inactivated previously is checked in step S588. If there is no activated codes, the process is ended. If an activated code is present, a random generation limitation 71 generates a value larger than "prenum" which is a NUM value during the previous simulation in step S589. Further, in step S590, an option for changing the random seed value SEED is added, generation of a collection of different random values is designated to execute simulation, and the process is finished. By changing these two values, a collection of different random values can be generated, and a possibility of activating the inactivation code can be increased. For example, if "prenum=5" is set, a random limiting test bench description T(cst2) 71b shown in FIG. 38 is obtained. In method 2, the generation limiting test bench description T(cst2) 71b is included in the driving test bench description T(drive) 61, an option for changing the random SEED value is added, and simulation is executed again in step S36.

(d) If there are no more inactivation codes that are reported by the code coverage measurement in step S558 of FIG. 32, or if no activation has been done at all for the inactivation codes reported during the previous simulation in step S558, the process is ended. For example, in method 2, the inactivation code 1 is deleted and the inactivation code 2 is eliminated in the second round of simulation, and the process is ended.

According to the second embodiment of the present invention, by automatically generating reliable driving test bench description from property description of a module, which gives an input to a verification target module and where there are no errors or omissions of specifications, time regarding test bench description and simulation time by generating a test vector, valid within specifications, are able to be shorten.

In addition, according to the second embodiment of the present invention, by automatically generating checking test bench description from the property description of the verification target module, it is possible to shorten time in the making of the test bench description. Moreover, according to the second embodiment of the present invention, by automatically generating top test bench description of a top hierarchy, for executing driving test bench description and the checking test bench description in parallel, it is possible to shorten time in the making of the test bench description.

Furthermore, according to the second embodiment of the present invention, by automatically determining whether or not an inactivation code cannot be activated based on insufficient test patterns or because of specifications, it is possible to prevent erroneous deletion of the inactivation in the former case, and enable the omission of useless simulation time in the latter case. According to the second embodiment of the present invention, by deleting an inactivation code determined impossible to be activated in specifications, it is possible to reduce an area. Moreover, according to the second embodiment of the present invention, by automatically generating random value generation limitation test bench description for activating an inactivation code, determined possible to be activated in specifications, and by reading this description to execute simulation, it is possible to increase verification accuracy by activating the inactivation code.

## OTHER EMBODIMENTS

Although the embodiments of the present invention have been described in detail, the invention may be embodied in other specific forms without departing from the spirit or essential characteristics thereof. The present embodiment is therefore to be considered in all respects as illustrative and not restrictive, the scope of the invention being indicated by the appended claims rather than by the foregoing description and all changes which come within the meaning and range of equivalency of the claims are therefore intended to be embraced therein.

The function of the LSI verification system of the first and second embodiment of the present invention may be programmed and saved in a computer-readable recording medium. For the LSI verification method of the first and second embodiment of the present invention, the programs saved in the recording medium is transferred to a memory in a computer system and then operated by its operating unit, thus putting the method in practice. The recording medium may be selected from semiconductor memories, magnetic disks, optical disks, optomagnetic disks, magnetic tapes, and any of the computer-readable recording mediums.

## Claims

1. An apparatus for design verification using logical simulation of a circuit description, having a plurality of hierarchies from top to bottom in accordance with abstraction levels of circuit components, the apparatus compsiring:

    a circuit description reading unit configured to read the circuit description;
    an analysis unit configured to analyze signal connection topologies between the hierarchies of the circuit description from top to bottom;
    a data storing unit configured to store data of the signal connection topologies;

a property reading unit configured to read properties of target modules implemented by the circuit components in the circuit description;

an inter-module property extraction unit configured to extract a property part having a signal communicating between the target modules:

a signal operation portion extraction unit configured to extract output operation properties, defining output operation of an output side module, and an expecting operation property, defining an expecting operation of an input side module among the properties of the target modules; and

a comparing unit configured to compare the output operation properties with the expecting operation properties.

2. The apparatus of claim 1 further comprising:

a mismatch detection unit configured to determine whether conditions of the output operation properties and the expecting operation properties match; and

a report generation unit configured to detect mismatched conditions and generating an error report.

3. The apparatus of claim 2 further comprising:

a waveform display unit configured to display a time domain variation of the signal regarding content of the mismatched conditions based on the error report.

4. An apparatus for design verification using logical simulation of a circuit description, a plurality of hierarchies from top to bottom in accordance with abstraction of circuit components, the apparatus comprising:

a circuit description reading unit configured to read the circuit description;

an analysis unit configured to analyze a signal connection topologies between the hierarchies of the circuit description from top to bottom;

a property generation unit configured to generate a property description constituted by a signal topology connected to a target module from the property description of a module providing an input to the target module, the target module being implemented by the circuit component;

a first test bench generation unit configured to generate a test vector and a first test bench description; and

a second test bench generation unit configured to generate a second test bench description for comparing a simulation output and a specification output from the property description of the target module.

5. The apparatus of claim 4 further comprising:

a third generation unit configured to generate a third test bench description in a higher hierarchy, executing the first and the second test bench description; and

a top model generation unit configured to generate top model description for a simulation, serving as an interface to a model descriptions of the target modules.

6. The apparatus of claim 4 in a simulation environment comprising the driving test bench description, the checking test bench description, the top test bench description, the top test bench description, and the top model description, further comprising:

a logical simulation unit configured to execute a logical simulation;

a code coverage measurement unit configured to execute code coverage measurement; and

an automatic determination unit configured to determine whether an inactivation code reported by the code coverage measurement unit can be activated within the interface specification, from the property description of the module providing the input to the target module.

7. The apparatus of claim 6 further comprising:

an inactivation code deletion unit configured to delete the reported inactivation code when the automatic determination unit determines that the inactivation code cannot be activated within the interface specifications: and

a reporting unit configured to report a line number of a file of the deleted code.

8. The apparatus of claim 6 further comprising:

a random value generation limiting test bench generation unit configured to generate a fourth test bench description that activates the reported inactivation code when the automatic determination unit determines that the inactivation code can be activated in specifications.

9. A computer implemented method for design verification using logical simulation of a circuit description having a plurality of hierarchies from top to bottom in accordance with abstraction of circuit components, the method comprising:

reading the circuit description;
analyzing signal connection topologies between the hierarchies of the circuit description from top to bottom;

storing data of the signal connection topologies to a data storing device;

reading properties of target modules implemented by the circuit components in the circuit description;

extracting a property part having a signal communicating between the target modules;

extracting an output operation property, defining output operation in an output side module, and an expecting operation property, defining an expecting operation of an input side module among the properties of the target module; and comparing the output operation properties with the expecting operation properties.

10. The method of claim 9 further comprising:

determining whether conditions of the output operation properties and the expecting operation properties match; and detecting mismatched conditions and generating an error report.

11. The method of claim 10 further comprising:

displaying a time domain variation of the signal regarding contents of the mismatched conditions based on the error report.

12. The method of claim 9 wherein when the conditions match, an interface specification has an additional coverage, and a hierarchical design method is not used, the method further comprises deleting a redundant part from the circuit description.

13. The method of claim 9 wherein when the conditions match, an interface specification has an additional coverage, and a hierarchical design method is used, the method further comprises inserting a register in the circuit description.

14. A computer implemented method for design verification using logical simulation of a circuit description having a plurality of hierarchies from top to bottom in accordance with abstraction of circuit components, the method comprising:

reading the circuit description;
analyzing signal connection topologies between the hierarchies of the circuit description from top to bottom;
generating a property description constituted by a signal topology connected to a target module from the property description of a module providing an input to the target module, the target module being implemented by the circuit components;

generating a test vector and a first test bench description; and

generating a second test bench description comparing a simulation output and a specification outputs from the property description of the target module.

15. The method of claim 14 further comprising:

generating a third test bench description in a higher hierarchy, executing the first and the second test bench descriptions; and generating a top model description for a simulation, serving as an interface to a model descriptions of the target modules.

16. The method of claim 14 further comprising:

executing a logical simulation and code coverage measurement wherein the simulation comprises the first test bench description, the second test bench description, the third test bench description and the top model description; and determining whether an inactivation code reported by measuring the code coverage can be activated within the interface specifications, from the property description of the module providing the input to the target module.

17. The method of claim 16 wherein when the inactivation code is determined as impossible to be activated within the specifications, the method comprises:

deleting the reported inactivation code; and reporting a line number of a file number of a deleted code.

18. The method of claim 16 wherein when the inactivation code is possible to be activated within the specifications, the method comprises generating a fourth test bench description that activates the reported inactivation code.

19. A computer program product for use with a design verification apparatus, wherein the apparatus uses logical simulation of a circuit description having a plurality of hierarchies from top to bottom in accordance with abstraction of circuit components, the computer program product comprising:

instructions configured to read the circuit description;
instructions configured to analyze signal connection topologies between the hierarchies of the circuit description from top to bottom:
instructions configured to store data of the signal connection topologies to a data storing device;

instructions configured to read properties of target modules implemented by the circuit components in the circuit description;

instructions configured to extract a property part having a signal communicating between the target modules:

instructions configured to extract an output operation property, defining output operation in an output side module, and an expecting operation property, defining an expecting operation of an input side module among the properties of the target module; and

instructions configured to compare the output operation properties with the expecting operation properties.

**20.** A computer program product for use with a design verification apparatus, wherein the apparatus uses logical simulation of a circuit description having a plurality of hierarchies from top to bottom in accordance with abstraction of circuit components, the computer program product comprising:

instructions configured to read the circuit description;

instructions configured to analyze signal topology connection topologies between the hierarchies of the circuit description from top to bottom;

instructions configured to generate a property description constituted by a signal connected to a target module from the property description of a module providing an input to the target module, the target module being implemented by the circuit component;

instructions configured to generate a test vector and a first test bench description; and

instructions configured to generate a second test bench description comparing a simulation output and a specification output from the property description of the target module.

# FIG. 1

CENTRAL PROCESSING UNIT (CPU) — 2

- DATA STORING UNIT — 9
- CIRCUIT DESCRIPTION READING UNIT — 10
- ANALYSIS UNIT — 11
- PROPERTY READING UNIT — 12
- INTER-MODULE PROPERTY EXTRACTION UNIT — 13
- SIGNAL OPERATION PORTION EXTRACTION UNIT — 14
- COMPARATOR — 15
- MISMATCH DETECTOR — 16
- REPORT GENERATOR — 17
- REDUNDANT PORTION DELETION UNIT — 18
- REGISTER INSERTION UNIT — 19
- DISPLAY UNIT — 20

INPUT DEVICE — 31

OUTPUT DEVICE — 32

INPUT/OUTPUT CONTROL DEVICE — 33

MAIN MEMORY — 35

DATA STORAGE DEVICE — 4

1

EP 1 324 232 A2

FIG. 2

# FIG. 3

DATA STORAGE DEVICE

| 1ST SECTION | 2ND SECTION | 3RD SECTION | 4TH SECTION | 5TH SECTION | 6TH SECTION |
|---|---|---|---|---|---|
| TOP (TOP) | MULTIPLIER (MULT) | CON | MULT:STB(STB),Done(Done),R_M(R_M)/CON: STB(STB),Done,R_M(R_M) | MULT:{if(C0(STB==1'b0)&& C1(forever(STB==1'b1))){ (B == 4'b0000) => C1(C11(Done)); ···}/ CON:{if{C0(RESETB == 1'b0) && C1(forever(RESETB == 1'b1)){ (OP== 2' b11) => C2(STB == 1'b0) && C3(forever(STB == 1'b1)); ;···} | MULT:{(C0(STB==1'b0)&& C1(forever(STB==1'b1)) => C1(within15(Done))+···} / CON:{C0(STB == 1'b1)) && C1(forever(STB == 1'b1)) && C1(within12(Done));···} |
| | | ALU | - | - | - |
| | CONT-ROLLER (CON) | MULT | CON:STB(STB),Done(Done),R_M(R_M)/MULT:STB(S ------------- | ------------- | |
| | | ALU | CON:R_A(R_A)/MULT:(R_A) | ------------- | ------------- |
| | RITHMETIC AND LOGIC UNIT(ALU) | MULT | - | - | - |
| | | CON | MULT:(R_A)/CON:R_A(R_A) | ------------- | ------------- |

EP 1 324 232 A2

## FIG. 4A

```
if(C0(STB==1'b0) && C1(forever(STB==1'b1))){------------------------
(B == 4'b0000) => C1(C11(Done));
(B == 4'b0001) => C1(C12(Done));
(B == 4'b0010) => C1(C12(Done));
(B == 4'b0011) => C1(C13(Done));
(B == 4'b0100) => C1(C12(Done));
(B == 4'b0101) => C1(C13(Done));
(B == 4'b0110) => C1(C13(Done));
(B == 4'b0111) => C1(C14(Done));
(B == 4'b1000) => C1(C12(Done));
(B == 4'b1001) => C1(C13(Done));
(B == 4'b1010) => C1(C13(Done));
(B == 4'b1011) => C1(C14(Done));
(B == 4'b1100) => C1(C13(Done));
(B == 4'b1101) => C1(C14(Done));
(B == 4'b1110) => C1(C14(Done));
(B == 4'b1111) => C1(C15(Done));

}
```

## FIG. 4B

```
if{C0(RESETB == 1'b0) && C1(forever(RESETB == 1'b1)){
(OP == 2'b11) => C2(STB == 1'b0) && C3(forever(STB == 1'b1)); ------------------------- ②
(OP == 2'b11) && C3(within12(Done)) => C3(within12(C1(current_state == 3'b100))); ---- ③
}

end
```

## FIG. 5

START

GENERATE DATA STORAGE DEVICE — S11

ANALYZE SIGNAL CORRELATION BETWEEN MODULES — S12

EXTRACT PROPERTIES OF SIGNAL EXISTS BETWEEN MODULES AND SIGNAL OPERATIONAL PORTION — S13

COMPARING — S15

S16
WHETHER CONDITIONS MATCH OR NOT? — NO

YES

S18
WHETHER SPACE EXISTS FOR SYSTEM SPECIFICATIONS OR NOT? — NO

YES

S19
WHETHER HIERARCHICAL DESIGN IS USED OR NOT? — NO

YES

S21
DELETE REDUNDANT PORTION

S20
INSERT REGISTER

S17
DETECT MISMATCH

END

FIG. 6A

START

READ RTL FILE — 101

READ ONE LINE — 102

IS IT A MODULE DECLARATION ? — 103
NO

YES

STORE MODULE NAME IN DATA STORAGE DEVICE — 104

PREPARE FILES FOR EACH MODULE NAME — 105

STORE DATA IN DATA STORAGE DEVICE — 106

READ ONE LINE — 107

END OF MODULE BLOCK? — 108
NO

YES

FINISH DATA STORAGE DEVICE — 109

END OF RTL FILE? — 110
NO

YES

MOVE TO 1ST POINT OF DATA STORAGE DEVICE — 111

(A)

READ DATA STORAGE DEVICE — 112

EXTRACTS MODULE NAME FROM DATA STORAGE DEVICE — 113

EXTRACTS CORRESPONDING MODULE DATA — 114

READ ONE LINE — 115

IS IT MODULE DECLARATION WITHIN DATA STORAGE DEVICE? — 116
NO

YES

EXTRACT CORRESPONDING MODULE DATA AND ADD DETECTED MODULE NAME TO 2ND SECTION OF DATA STORAGE DEVICE — 117

END OF MODULE NAME DATA? — 118
NO

(B) YES

# FIG. 6B

Ⓑ

FINISH DATA STORAGE DEVICE ～119

Ⓐ ← NO — THE LAST MODULE NAME IN DATA STORAGE DEVICE ? ⌐120

YES

MOVE TO 1ST POINT OF DATA STORAGE DEVICE ～121

READ DATA STORAGE DEVICE ～122

READ MODULE NAME FROM DATA STORAGE DEVICE ～123

READ CORRESPONDING MODULE NAME DATA ～124

IS THERE A 2ND SECTION DATA EXISTS ? ⌐125 — NO

YES

DEFINE AS HIERARCHICAL MODULE NAME ～126

MOVE TO 1ST POINT OF DATA STORAGE DEVICE ～127

READ DATA STORAGE DEVICE ～128

READ CORRESPONDING MODULE NAME DATA ～129

YES — IS LOWER CLASS MODULE IS INCLUDED ? ⌐130

END ALL PROCESSES

NO

DEFINE AS TOP MODULE ～131   136

READ 2ND SECTION DATA OF TOP MODULE ～132

PREPARE TWO COMBINATIONS FROM 2ND SECTION DATA, AND WRITE AS 3RD SECTION DATA ～133

EXTRACT INTER-MODULE CONNECTION INFORMATION (TERMINAL, WRITING) OF 3RD SECTION DATA FROM DATA OF TOP MODULE, AND WRITE AS 4TH SECTION DATA ～134

NO — END OF 3RD SECTION DATA? ⌐135

YES

END

# FIG. 7A

40a

```
PI.A => MULT.A
PI.B=>MULT.B
PI.CLK=>MULT.CLK
PI.RESETB=>MULT.RESETB
CON.STB=>MULT.STB
```

# FIG. 7B

40b

```
PI.CLK=>CON.CLK
PI.RESETB=>CON.RESETB
PI.OP => CON.OP
MULT.Done => CON.Done
MULT.RESULT => CON.R_M
ALU.RESULT => CON.R_A
```

FIG. 8A

START

READ DATA FROM DATA STORAGE DEVICE — S201

READ 4TH SECTION DATA FROM DATA STORAGE DEVICE — S202

INITIALIZE TARGET PROPERTY FLAG TO "0" — S210

SEARCH TARGET PROPERTY REGARDING COMMON TERMINAL

NO — IS IT A PROPERTY CONCERNING COMMON TERMINAL? — S212 / S211

SET TARGET PROPERTY FLAG TO "1" — S213

READ PROPERTY FILE OF CORRESPONDING MODULE — S214

READ ONE LINE OF THE PROPERTY — S215

NO — IS 4TH SECTION DATA INCLUDED? — S216

CONVERT SIGNAL NAME INTO NAME OF TOP HIERARCHY, AND WRITE PROPERTIES IN 5TH SECTION — S217

C

INITIALIZE REFERENCE PROPERTY FLAG TO "0" — S220

SEARCH REFERENCE PROPERTY REGARDING COMMON TERMINAL

NO — IS IT A PROPERTY CONCERNING COMMON TERMINAL? — S221 / S223

YES — S222

SET REFERENCE PROPERTY FLAG TO "1"

READ PROPERTY FILE OF CORRESPONDING MODULE — S224

READ ONE LINE OF THE PROPERTY

S225 — IS 4TH SECTION DATA INCLUDED? — S226

CONVERT SIGNAL NAME INTO NAME OF TOP HIERARCHY, AND WRITE PROPERTIES IN 5TH SECTION

E — S227

G

D

F

# FIG. 8B

Ⓒ

**S218** IS IT A LAST LINE OF PROPERTY FILE? — NO → Ⓓ

YES

**S228** IS IT A LAST LINE OF PROPERTY FILE? — NO → Ⓕ

Ⓔ

YES

**S230** WHETHER TARGET PROPERTY FLAG IS EQUAL TO "1" AND REFERENCE PROPERTY FLAG IS EQUAL TO "1"? — NO → **S231** OUTPUT PROPERTY INSUFFICIENT MESSAGE

YES

**S232** WHETHER ONE OF PROPERTY FLAGS IS 1? — NO

YES → **S233** OUTPUT INSUFFICIENT PROPERTY

**S234** END OF 4TH SECTION DATA? — NO → Ⓖ

YES

END

EP 1 324 232 A2

## FIG. 9

```
                    ┌─────────────┐
                    │    START    │
                    └──────┬──────┘
                           ↓
              ┌────────────────────────┐
              │  READ DATA STORAGE     │ ~ S301
              │       DEVICE           │
              └────────────┬───────────┘
                           ↓
              ┌────────────────────────┐
              │  READ 5TH SECTION      │ ~ S302
              │       DATA             │
              └────────────┬───────────┘                    S320
                           │─────────────────────────────┐
                           ↓                              ↓
              ┌────────────────────────┐      ┌────────────────────────┐
              │  READ PROPERTIES OF    │ ~S310│  PREPARE AND READ      │
              │    TARGET MODULE       │      │   PROPERTIES OF        │
              └────────────┬───────────┘      │  REFERENCE MODULE      │
                           ↓                  └────────────┬───────────┘
              ┌────────────────────────┐      ┌────────────────────────┐
              │  EXTRACT PROPERTIES    │ ~S311│  EXTRACT PROPERTIES    │
              │ OTHER THAN COMMON      │      │    OTHER THAN          │
              │     TERMINAL           │      │  COMMON TERMINAL       │
              └────────────┬───────────┘ S312 └────────────┬───────────┘ S321
                           ↓                               ↓
              ┌────────────────────────┐      ┌────────────────────────┐
              │  READ NEXT PROPERTY    │      │  READ NEXT PROPERTY    │
              └────────────┬───────────┘      └────────────┬───────────┘ S322
                           ↓                               ↓
                        ╱──S313╲                        ╱────╲
                  NO  ╱  IS IT   ╲              NO     ╱ IS IT ╲
                 ◄───╱ POSSIBLE TO╲             ◄─────╱POSSIBLE TO╲
                    ╲REPLACE PROPERTIES         ╲REPLACE PROPERTIES╲
                    ╲OTHER THAN COMMON╱          ╲OTHER THAN COMMON╱
                     ╲  TERMINAL? ╱               ╲ TERMINAL? ╱ S323
                      ╲──┬──╱                      ╲──┬──╱
                         │ YES                S324   │ YES
                         ↓                           ↓
              ┌────────────────────────┐ S314 ┌────────────────────────┐
              │  REPLACE TARGET        │      │  REPLACE REFERENCE     │
              │    PROPERTIES          │      │    PROPERTY            │
              └────────────┬───────────┘      └────────────┬───────────┘
                           ↓                               ↓
              ┌────────────────────────┐ S315 ┌────────────────────────┐
              │  WRITE DATA IN 6TH     │      │  WRITE DATA IN 6TH     │
              │  SECTION OF DATA       │      │  SECTION OF DATA       │
              │  STORAGE DEVICE        │      │  STORAGE DEVICE        │
              └────────────┬───────────┘      └────────────┬───────────┘ S325
                           ↓←──────────────────────────────┘
                        ╱──S330╲
                  NO  ╱   ALL    ╲
                 ◄───╱ PROPERTIES ARE╲
                    ╲  REPLACED? ╱
                      ╲──┬──╱
                         │ YES
                         ↓
                    ┌─────────┐
                    │   END   │
                    └─────────┘
```

# FIG. 10A

```
1 if{C0(RESETB == 1'b0) && C1(forever(RESETB == 1'b1)){
2 (OP == 2'b11) => C2(STB == 1'b0) && C3(forever(STB == 1'b1));
3 (OP == 2'b11) && C3(within12(Done)) => C3(within12(C1(current_state == 3'b100)));
4 }
```

# FIG. 10B

```
1 if{C0(RESETB == 1'b0) && C1(forever(RESETB == 1'b1)){
2 C2(STB == 1'b0) && C3(forever(STB == 1'b1))
3 && C3(within12(Done)) => C3(within12(C1(current_state == 3'b100)));
4 }
```

## FIG. 11

```
        ( START )
            │
            ▼
┌─────────────────────────────┐
│  READ DATA STORAGE DEVICE   │──── S401
└─────────────────────────────┘
            │
            ▼
┌─────────────────────────────┐
│  READ DATA 6TH SECTION DATA │──── S402
└─────────────────────────────┘
            │
            ▼
┌─────────────────────────────┐
│     SORT EACH PROPERTY      │──── S403
└─────────────────────────────┘
            │
            ▼
┌─────────────────────────────┐
│ DELETE EQUIVALENT EQUATION  │──── S404
└─────────────────────────────┘
            │
            ▼                        S405
         ╱ IS THERE  ╲
  NO    ╱ ANY UNDELETED ╲
◄──────╱  EQUATION?      ╲
       ╲                 ╱
        ╲               ╱
            │ YES
            ▼
┌─────────────────────────────┐
│      COMPARE EQUATIONS      │──── S406
└─────────────────────────────┘
            │
            ▼
         ( END )
```

# FIG. 12

START

READ RTL FILE ~S411

SEPARATE DESCRIPTION OF CON
PORTION BETWEEN REGISTERS
OF TARGET SIGNAL ~S412

SPECIFY REGISTER INSERTION ENABLE
PLACE (SEPARATE FOR EACH
INTERMEDIATE VARIABLE) ~S413

ADD REGISTER TO CON SEPARATED
FOR EACH INTERMEDIATE VARIABLE
IN COMBINATION OF NUMBER OF
REGISTER INSERTION ENABLE PLACES
AND OUTPUT TO A FILE ~S414

END

# FIG. 13

EP 1 324 232 A2

# FIG. 14A

```
if(C0(STB  ==  1'b0)  &&  C1(forever(STB==1'b1))){
(B  ==  4'b0000)  =>  C1(C11(Done));
(B  ==  4'b0001)  =>  C1(C12(Done));
(B  ==  4'b0010)  =>  C1(C12(Done));
(B  ==  4'b0011)  =>  C1(C13(Done));
}
```

# FIG. 14B

```
if{C0(RESETB  ==  1'b0)  &&  C1(forever(RESETB  ==  1'b1)){
(OP  ==  2'b11)  =>  C2(STB  ==  1'b0)  &&  C3(forever(STB  ==  1'b1));
(OP  ==  2'b11)  &&  C3(within12(Done))  =>  C3(within12(C1(current_state  ==  3'b100)));
}

end
```

EP 1 324 232 A2

# FIG. 15

PROPERTY I (PL) — 62

PROPERTY T (PL) — 66

MODEL I (HDL) — 60

TEST BENCH DRIVE — 61
GENERATION — GENERATE
(VL)
TOP
GENERATE

MODEL TEST
MODEL T (HDL) — 63, 64
GENERATE
DETERMINATION
REDUNDANT CODE?

ACTUAL MEASURED VALUE

TEST BENCH CHECK
COMPARE — 67
EXPECTED VALUE
(VL)
GENERATE — 68
TEST BENCH
SIMULATION — 80

REPORT — 65
CODE COVERAGE — 69

EP 1 324 232 A2

**FIG. 16**

**CPU**

| CIRCUIT DESCRIPTION READING UNIT | ~10 |

| ANALYSIS UNIT | ~11 |

| PROPERTY GENERATION UNIT | ~21 |

**TEST BENCH GENERATION UNIT** ~22

| DRIVING TEST BENCH GENERATION UNIT | ~22a |

| CHECKING TEST BENCH GENERATION UNIT | ~22b |

| TOP TEST BENCH GENERATION UNIT | ~22c |

| RANDOM VALUE GENERATION LIMITING TEST BENCH GENERATION UNIT | ~22d |

| TOP MODEL GENERATION UNIT | ~23 |

| LOGICAL SIMULATION UNIT | ~24 |

| CODE COVERAGE MEASUREMENT UNIT | ~25 |

| AUTOMATIC DETERMINATION UNIT | ~26 |

| INACTIVATION CODE DELETION UNIT | ~27 |

| REPORTING UNIT | ~28 |

INPUT/OUTPUT CONTROL DEVICE 33

INPUT DEVICE 31

OUTPUT DEVICE 32

MAIN MEMORY 35

DATA STORAGE DEVICE 4

1

2

EP 1 324 232 A2

## FIG. 17

FIG. 18

EP 1 324 232 A2

# FIG. 19

FROM LOWER LEFT

65b — CODE COVERAGE REPORT

S39 — IS THERE AN INACTIVATION CODE?

YES — IS THERE POSSIBILITY FOR ACTIVATION IN A SPECIFICATION ? — NO

63 — MODEL T M(T)    59 — MODEL TOP M(TOP)    MODEL I M(I) — 60

S31 — ANALYZE SIGNAL CORRELATION BETWEEN MODULES

PROPERTY I P(I)    INPUT CONNECTION RELATION — 69

62    S32 — EXTRACT RELATIONAL PROPERTY

S41 — DELETE INACTIVATION CODE

NO — S40

YES

DELETION REPORT — 70

S42 — IS THERE POSSIBILITY FOR ACTIVATION IN A SPECIFICATION ?

74 — PROPERTY P(I->T)    PROPERTY T P(T) — 66

S33 — CONVERT DESCRIPTION    S34 — CONVERT DESCRIPTION    GENERATE LIMITATION — S43

61 — TEST BENCH T(drive)    TEST BENCH T(check) — 67    RANDOM VALUE GENERATION LIMIT

NO

YES

S44 — WHETHER PREVIOUS INACTIVATION CODE IS NOT ACTIVATED ?

S35 — GENERATE DESCRIPTION

71    S45 — GENERATE LIMITATION    NO

64 — MODEL M(TEST)    TEST BENCH T(TOP) — 68

NEW SEED VALUE & NEW NUM VALUE — 72

YES

S38 — MANUAL CORRECTION

EXECUTE LOGICAL SIMULATION & CODE COVERAGE MEASUREMENT — S36

ERROR REPORT — 65a

NO — S37 — WHETHER A SIMULATION MATCHES?

YES
TO UPPER RIGHT

END

# FIG. 20

```
        ┌─────────────┐
        │    START    │
        └──────┬──────┘
               │
               ▼
┌──────────────────────────────────┐
│          READ CIRCUIT            │ ～ S501
└──────────────┬───────────────────┘
               │
               ▼
┌──────────────────────────────────┐
│  ANALYZE HIERARCHICAL STRUCTURE  │
│  & SIGNAL CONNECTION RELATION    │ ～ S502
│    BETWEEN LOWER HIERARCHY       │
└──────────────┬───────────────────┘
               │
               ▼
┌──────────────────────────────────┐
│   OBTAIN MODULE STRUCTURE OF     │
│        EXECUTED CIRCUIT          │ ～ S503
└──────────────┬───────────────────┘
               │
               ▼
┌──────────────────────────────────┐
│    OBTAIN INPUT CONNECTION       │
│   RELATION C(CON)&C(ALU) OF      │ ～ S504
│          CON&ALU                 │
└──────────────┬───────────────────┘
               │
               ▼
        ┌─────────────┐
        │     END     │
        └─────────────┘
```

# FIG. 21

```
TOP ─┬─ CON (CON)
     │
     └─ ALU (ALU) ─┬─ SELECTOR (SELECTOR)   :REGISTER SELECTION
                    │                         CONTROLLER
                    ├─ REG (AREG)            :REGISTER FOR DATA A
                    │
                    ├─ REG (BREG)            :REGISTER FOR DATA B
                    │
                    ├─ OPREG (OPREG)         :REGISTER FOR OPERATOR
                    │                         (OP)
                    ├─ alu8 (alu8)           :ARITHMETIC AND LOGIC
                    │                         CIRCUIT
                    └─ REG(RREG)             :REGISTER FOR OPERATION
                                              RESULT (OUT)
```

EP 1 324 232 A2

# FIG.22A

<<INPUT CONNECTION RELATION OF CON: C(CON)>>

    PI.CLK->CON.CLK
    PI.IN->CON.CIN

# FIG.22B

<<INPUT CONNECTION RELATION OF ALU: C(ALU)>>

    PI.CLK->ALU.CLK
    CON.COUT->ALU.AIN
    CON.CSEL->ALU.ASEL
    CON.CRESET->ALU.ARESET

FIG. 23

START

ACQUIRE PROPERTY DESCRIPTION
OF MODULE T&I — S506

SEARCH SIGNAL NAME OF
MODULE I FOR P(I) — S507

S508

IS THERE
ANY SIGNAL NAME ON
LEFT SIDE OF
C(I)?

YES

NO

DELETE THE SECTION — S510

LEAVE UNDISTURBED — S509

S511

IN THE
MIDDLE OF PROCESS?

YES

NO

EXTRACT PROPERTY DESCRIPTION
P(I-(T) FOR PROPERTY DESCRIPTION P(I) — S512

END

# FIG. 24A

```
<<PROPERTY DESCRIPTION P(ALU) OF SINGLE VERIFICATION OF ALU>>

//PROPERTY DESCRIPTION P(ALU-1)
C0(ASEL==2'b00) => C1(A ==AIN);
C0(ASEL==2'b01) => C1(B ==AIN);
C0(ASEL==2'b10) => C1(OP==AIN[2:0]);

//PROPERTY DESCRIPTION P(ALU-2)
if(C0(ASEL!=2'b10) && C1(ASEL==2'b10)){
C2(OP==3'b000) => C3(AOUT) == C2(A & B).
C2(OP==3'b001) => C3(AOUT) == C2(A | B);
C2(OP==3'b010) => C3(AOUT) == C2(A ^ B);
C2(OP==3'b011) => C3(AOUT) == C2(A + B);
C2(OP==3'b100) => C3(AOUT) == C2(A - B);
C2((OP==3'b101)|(OP==3'b110)|(OP==3'b111)) => C3(AOUT == 8'b0000_0000);
}

//PROPERTY DESCRIPTION P(ALU-3)
if(C0(ARESET==1'b0)){
C1(A==8'b0000_0000);
C1(B==8'b0000_0000);
C1(OP==3'b000);
}
```

# FIG. 24B

```
<<SINGLE VERIFICATION PROPERTY DESCRIPTION P(CON) OF CON>>
//PROPERTY DESCRIPTION P(CON-1)
if (C0(STATE == EMPTY)){
    C1((A==CIN[7:0])&&(B==CIN[15:8])&&(OP==CIN[18:16])&&(STATE==FULL));
}

//PROPERTY DESCRIPTION P(CON-2)

if(C0(STATE == FULL)){
  C0(CRESET==1'b1);
  C1(CRESET==1'b0);
C2((CRESET==1'b1)&& (CSEL==2'b00)&& (COUT==A));
C3((CRESET==1'b1)&& (CSEL==2'b01)&& (COUT==B));
C4((CRESET==1'b1)&& (CSEL==2'b10)&& (COUT==OP)&&(STATE==EMPTY));
}
```

# FIG. 24C

```
//PROPERTY DESCRIPTION P(CON->ALU)

C0(CRESET==1'b1);
C1(CRESET==1'b0);
C2((CRESET==1'b1)&& (CSEL==2'b00)&& (COUT==A));
C3((CRESET==1'b1)&& (CSEL==2'b01)&& (COUT==B));
C4((CRESET==1'b1)&& (CSEL==2'b10)&& (COUT==OP));
```

# FIG. 25

```
              ( START )
                  |
                  v
┌──────────────────────────────────────┐
│              P(I->T)                   │ ~S514
└──────────────────────────────────────┘
                  |
                  v
┌──────────────────────────────────────┐
│  CONVERT SIGNAL NAME OF LEFT SIDE OF   │ ~S516
│  C(T) INTO SIGNAL NAME OF RIGHT SIDE   │
└──────────────────────────────────────┘
                  |
                  v
┌──────────────────────────────────────┐
│  CONVERT INPUT (IN) INTO DESCRIPTION   │ ~S517
│   "rand.IN" AND ADJUST BIT WIDTH       │
└──────────────────────────────────────┘
                  |
                  v
┌──────────────────────────────────────┐
│  EXTRACT DESCRIPTION REGARDING TIME    │ ~S518
│               PHASE                    │
└──────────────────────────────────────┘
                  |                      S519
                  v
      <  IS IT AN ABSOLUTE TIME?  >
                  |                      S520
                  v
┌──────────────────────────────────────┐
│      CONVERT INTO RELATIVE TIME        │
└──────────────────────────────────────┘
                  |
                  v
┌──────────────────────────────────────┐
│  CONVERT "==" INTO "=" AND CONVERT     │ ~S521
│          "&&" INTO ","                 │
└──────────────────────────────────────┘
                  |
                  v
┌──────────────────────────────────────┐
│      ADD "for LOOP" DESCRIPTION        │ ~S522
└──────────────────────────────────────┘
                  |
                  v
┌──────────────────────────────────────┐
│            DESCRIBE "@n"               │ ~S523
└──────────────────────────────────────┘
                  |
                  v
┌──────────────────────────────────────┐
│  ADD SIMULATION END DESCRIPTION "exit(0)", │ ~S524
│  VARIABLE DECLARATION, "task(CLASS NAME │
│  TASK BELONG(::(TASK NAME(){(PROCESSING │
│       SEQUENCE MAIN BODY(}"             │
└──────────────────────────────────────┘
                  |
                  v
┌──────────────────────────────────────┐
│       GENERATE T(drive_TASK)           │ ~S525
└──────────────────────────────────────┘
                  |
                  v
┌──────────────────────────────────────┐
│ GENERATE T(drive_DECLARE) FROM S517&S524 │ ~S526
└──────────────────────────────────────┘
                  |
                  v
               ( END )
```

## FIG. 26A

≤61a

```
//TASK TEST BENCH DESCRIPTION T(drive_TASK)

task DRIVE::drive() {
    int i;
for(i = 0; i <= NUM; i++){
@1  ARESET=1'b1;
@1  ARESET=1'b0;
@1  ARESET=1'b1, ASEL=2b00, AIN=rand.A;
@1       ASEL=2'b01, AIN=rand.B;
@1       ASEL=2'b10, AIN={5'b00000,rand OP};   (BIT WIDTH ADJUSTMENT)
       @n
}
exit(0);
}
```

## FIG. 26B

≤61b

```
//CLASS DECLARATION TEST BENCH DESCRIPTION T(drive_DECLARE)

    class DRIVE {
    rand bit[7:0] A;
        rand bit[7:0] B;
        rand bit[2:0] OP;
        rand integer NUM;
        task drive();
    }
```

## FIG. 27A

```
//MIXED DESCRIPTION PT(ALU-2)#1

if((ASEL.3!=2'b10)&&(ASEL.2==2'b10)){
OP.1==3'b000 => AOUT==A.1 & B.1;
}
```

## FIG. 27B

```
//MIXED DESCRIPTION PT(ALU-2)#2

if((ASEL.1!=2'b10)&&(ASEL==2'b10)){
@1  OP==3'b000 =>AOUTexp== A & B; (GENERATE EXPECTED VALUE AND
                                   STORE VARIABLE OF THE EXPECTED
                                   VALUE)

@1  AOUT ==AOUTexp                 (COMPARE ACTUALLY MEASURED
}                                  VALUE WITH EXPECTED VALUE)
```

**FIG. 28**

START

OBTAIN P(T-n) — S530

CONVERT REGARDING TIME PHASE USING .n — S531

CONVERT REGARDING TIME PHASE USING @ — S532

CONVERT CONDITIONAL SENTENCE — S533

ADD DESCRIPTION FOR FORMING while LOOP & TASK BLOCK — S534

OBTAIN T(T-n) — S535

OBTAIN n OF @n — S536

DESCRIBE INSTANTIATION FOR CLASS WHERE TASK T(T-n) BELONGS — S537

DESCRIBE "fork/join" STATEMENT CITING TASK NAMES TO BE EXECUTED IN PARALLEL — S538

ADD DESCRIPTION FOR FORMING TASK BLOCK (TASK NAME: check(all) — S539

GENERATE T(T-all) — S540

GENERATE T(check(TASK) — S541

END

## FIG. 29A

```
//TASK TEST BENCH DESCRIPTION T(ALU-2)

if((ASEL.1!=2'b10)&&(ASEL==2'b10)){
@1  case (OP){
3'b000:  AOUTexp= A & B;
3'b001:  AOUTexp= A | B;
3'b010:  AOUTexp= A ^ B;
3'b011:  AOUTexp= A + B;
3'b100:  AOUTexp= A - B;
default:  AOUTexp= 8'b0000_0000;
      }
    @1  AOUT  == AOUTexp;
}
```

## FIG. 29B

```
//TASK TEST BENCH DESCRIPTION T(ALU-2)

task CHECK::check_2() {
bit[7:0] AOUTexp;
    while(1) {
if((ASEL.1!=2'b10)&&(ASEL==2'b10)){
@1  case (OP){
3'b000:  AOUTexp= A & B;
3'b001:  AOUTexp= A | B;
3'b010:  AOUTexp= A ^ B;
3'b011:  AOUTexp= A + B;
3'b100:  AOUTexp= A - B;
default:  AOUTexp= 8'b0000_0000;
         }
      @1  AOUT  == AOUTexp;
}
   }
}
```

## FIG. 29C

```
//TASK TEST BENCH DESCRIPTION T(ALU-1)

task CHECK::check_1() {
   while(1) {
      if(ASEL  == 2'b00){
         @1 A  == AIN;
      }else if(ASEL  == 2'b01){
         @1 B  == AIN;
      }else if(ASEL  == 2'b10){
         @1 OP  == AIN;
      }
   }
}
```

# FIG. 30A

```
//TASK TEST BENCH DESCRIPTION T(ALU-3)

task CHECK::check_3() {
   while(1) {
      if(ARESET == 1'b0){
         @1;
         A == 8'b00000000,
         B == 8'b00000000,
         OP == 3'b000;
      }
   }
}
```

# FIG. 30B

```
//TASK TEST BENCH DESCRIPTION T(drive_TASK)

task DRIVE::drive() {
     int i;
for(i = 0; i <= NUM; i++){
@1  ARESET=1'b1;                                  (T=1)
@1  ARESET=1'b0;                                  (T=2)
@1  ARESET=1'b1,ASEL=2b00, AIN=rand.A;            (T=3)
@1         ASEL=2'b01, AIN=rand.B;                (T=4)
@1         ASEL=2'b10, AIN={5b00000,rand.OP};     (T=5; n=0 IN CASE OF
                                                      FINAL TIME AT n=0)
        ⎧ @1                                      (T=6)
        ⎪ @1                                      (T=7)
      n⎨ @1                                      (T=8)
        ⎪  ⋮
        ⎩  ⋮

}
exit(0);
}
```

```
//TASK TEST BENCH DESCRIPTION T(ALU_all)

task CHECK::check_all() {
    CHECK check;
fork
{check.check_1();}
{check.check_2();}
{check.check_3();}
join
}
```

# FIG. 30C

```
//CLASS DECLARATION TEST BENCH
DESCRIPTION T(ckeck_DECLARE)

class CHECK {
    taskcheck_all();
    task check_1();
    task check_2();
    task check_3();
}
```

# FIG. 30D

# FIG. 31

( START )

↓

ACQUIRE T(check(DECLARE) ~ S542

↓

DESCRIBE INSTANTIATION OF CLASS WHERE T(drive) & T(check) BELON ~ S543

↓

CITE TASK NAMES TO BE PARALLELLY EXECUTED IN "fork/join" DESCRIPTION ~ S544

↓

DESCRIBE DESCRIPTION "main(MAIN BLOCK NAME({(PROCESSING MAIN BODY(}" FOR FORMING MAIN BLOCK ~ S545

↓

GENERATE T(TOP) ~ S546

↓

OBTAIN M(T) ~ S547

↓

DECLARATION SECTION:
DESCRIBE MODULE DECLARATION, SIGNAL input AND output DECLARED IN VERIFICATION TARGET MODULE BY wire DECLARATION, AND reg DECLARATION OF TOP CLOCK TEST CLK FOR CLOCK GENERATION ~ S548

↓

INSTANCE SECTION:
DESCRIBE INSTANCE OF MODEL DESCRIPTION M(T) OF VERIFICATION TARGET MODULE ~ S549

↓

CLOCK GENERATION SECTION:
GENERATE TOP CLOCK, ALLOCATE GENERATED TOP CLOCK TO CLOCK OF VERIFICATION TARGET MODULE, AND DESCRIBE INITIAL VALUE OF TOP CLOCK ~ S550

↓

GENERATE M(TEST) ~ S551

↓

OBTAIN INTEGRATED SIMULATION ENVIRONMENT FROM T(TOP), T(drive), T(check), AND M(TEST) ~ S552

↓

( END )

FIG. 32A

```
//TEST BENCH DESCRIPTION T(TOP)

main TEST{
DRIVE drive;
   CHECK check;
   fork
{drive.drive();}
{check.check();}
join
}
```

FIG. 32B

```
//SIMULATING MODEL DESCRIPTION M(TEST)
module TEST;
reg          TEST_CLK;
wire       CLK,ARESET;
wire  [1:0]  ASEL;
wire [7:0]  AIN;
wire [7:0]  AOUT;

 ALU ALU ( .AOUT(AOUT), .CLK(CLK), .ARESET(ARESET), .AIN(AIN), .ASEL(ASEL));

 assign CLK = TEST_CLK;
 always #5 TEST_CLK = ~TEST_CLK;
   initial begin TEST_CLK = 1'b0; end
endmodule
```

EP 1 324 232 A2

# FIG. 33

START

EXECUTE LOGICAL SIMUL ATION &
COVERAGE MEASUREMENT IN
WHICH M(T) IS TARGETED — S554

REPORT NUM & SEED VALUE — S555

CORRECT MODEL — S556

WHETHER
THERE IS ANY ERROR? — S557
YES → PROCEED TO
STEP S31

S559

NO

WHETHER
INACTIVATION CODE
IS PRESENT? — S558
NO → END

YES

END

## FIG. 34A

```
//INACTIVATION CODE REPORT R(UA1)

always @(sel ) begin
    case (sel )
        2'b00 :  begin  aen= 1'b1;  ben= 1'b0;  sen= 1'b0;  end
        2'b01 :  begin  aen= 1'b0;  ben= 1'b1;  sen= 1'b0;  end
        2'b10 :  begin  aen= 1'b0;  ben= 1'b0;  sen= 1'b1;  end
        default :  begin  aen= 1'b0;  ben= 1'b0;  sen= 1'b0;  end  (UNACTIVATEDNo.1)
    endcase
end
```

## FIG. 34B

```
//INACTIVATION CODE REPORT R(UA2)

always @ ( a or b or op )
case ( op )
3'b000:  begin  alu_out= a & b; end
        3'b001:  begin  alu_out= a l b;  end
        3'b010:  begin  alu_out= a ^ b;  end
        3'b011:  begin  alu_out= a + b;  end
        3'b100:  begin  alu_out= a - b; end
        default:  begin  alu_out= 8'b0000_0000; end   (UNACTIVATED No.2)
```

EP 1 324 232 A2

**FIG. 35**

START

SET SIGNAL OF INACTIVATION CODE DETECTED IN M(T) TO S(T), AND SET ITS VALUE TO VAL — S561

WHETHER IT IS VAL default STATEMENT OF case STATEMENT OR else OF if STATEMENT? — S562

OBTAIN VALUE EQUIVALENT TO default OR else — S563

TRACE SIGNAL S(T) IN M(T) — S564

OBTAIN SIGNAL NAME S(I) IN MODEL M(I) OF SIGNAL S(T), AND SET TO SIG — S565

SET VERIFICATION TARGET TO PROPERTY DESCRIPTION P(I) IN WHICH SIG IS DESCRIBED — S566

SEARCH SIGNAL NAME SIG DESCRIBED ON LEFT SIDE OTHER THAN CONDITIONAL STATEMENT — S567

S568 WHETHER SEARCHED DESCRIPTION GIVE FIXED VALUE ON RIGHT SIDE?

S571 TRACE VERIFICATION TARGET SIG IN M(I)

S569 STORE FIXED VALUE

S572 WHETHER VALUE TO BE TAKEN CAN BE SPECIFIED AND TRACED?

S570 WHETHER IT IS MIDDLE OF PROPERTY DESCRIPTION?

S573 STORE ITS IMITATION

S574 WHETHER ITS SIGNAL IS MAIN INPUT SIGNAL?

S576 WHETHER VALUE OF VAL IS INCLUDED IN LIMITATION RANGE OF FIXED VALUE OBTAINED IN S569 OR VALUE OBTAINED IN S573?

S575 SET NEW SIG VERIFICATION TARGET TO ANOTHER P(I)

S578 DETERMINE THAT ACTIVATION IS POSSIBLE

S577 DETERMINE THAT ACTIVATION IS IMPOSSIBLE

END

**FIG. 36**

START

WHETHER ACTIVATION IS POSSIBLE IN SPECIFICATIONS? — S576

ACTIVATED / YES

INACTIVATED / NO

ACTIVATED

GENERATE TEST BENCH T(drive-cst) — S585

RE-SIMULATE T (drive) IN STEP S554

DELETE INACTIVATION CODE — S581

REPORT LINE NUMBER OF DELETED INACTIVATION CODE — S582

RETURN TO PROCESS AT STEP S501

S588 — WHETHER TO CHECK AS TO PRESENCE OF CODE ACTIVATED AMONG PREVIOUS INACTIVATION CODES?

NO

YES

GENERATE RANDOM GENERATION LIMITATION FOR GENERATING VALUE LARGER THAN NUM VALUE WHEN NUM VALUE IS prenum — S589

EXECUTE SIMULATION BY ADDING OPTION FOR CHANGING RANDOM SEED VALUE SEED, AND GENERATE COLLECTION OF DIFFERENT RANDOM VALUES — S590

END

## FIG. 37

```
//MODIFIED MODEL DESCRIPTION M(ALU-1)
always @ ( sel ) begin
      case ( sel )
                  2'b00 :  begin  aen=1'b1;  ben=1'b0;  sen= 1'b0;  end
                  2'b01 :  begin  aen=1'b0;  ben=1'b1;  sen= 1'b0;  end
                  2'b10 :  begin  aen=1'b0;  ben=1'b0;  sen= 1'b1;  end
//Spec. Unactivate  default : begin  aen=1'b0;  ben=1'b0;  sen= 1'b0,  end
      endcase
end
```

## FIG. 38

```
//RANDOM LIMITING TEST BENCH DESCRIPTION T(cst1)

constraint drive_cst1 {
   OP >= 3'b101; OP <= 3'b111;
}
```

## FIG. 39

```
//RANDOM LIMITING TEST BENCH DESCRIPTION T(cst2)

constraint drive_cst2 {
   NUM > 5;
}
```